# EUROPEAN PATENT APPLICATION

(11) **EP 1 843 384 A1**
(43) Date of publication of application: **10.10.2007**
(21) Application number: 05811515.5
(22) Date of filing: 30.11.2005
(51) Int. Cl.: H01L 21/027, G03F 7/20

(54) **EXPOSURE DEVICE AND DEVICE MANUFACTURING METHOD**

(30) Priority: 02.12.2004 JP 2004349730; 14.06.2005 JP 2005173339
(71) Applicant: NIKON CORPORATION, Tokyo 100-8331 (JP)
(72) Inventor: OKADA, Takaya, c/o NIKON CORPORATION, IP Dept., Tokyo (JP); SUGAWARA, Ryu, c/o NIKON CORPORATION, IP Dept., Tokyo (JP)
(74) Representative: Viering, Jentschura & Partner
(86) International application number: PCT/JP2005/021977
(87) International publication number: WO 2006/059636

(57) **Abstract**

An exposure apparatus emits exposure light onto a substrate (P) via a projection optical system (PL) to expose the substrate (P). The projection optical system (PL) includes a first optical element (LS1) closest to an image plane of the projection optical system (PL) and a second optical element (LS2) closest to the image plane next to the first optical element (LS1). The exposure apparatus is disposed at a position higher than a lower surface (T3) of the second optical element (LS2) and includes a second collection port (42) that recovers a second liquid (LQ2) held in a second space (K2) between an upper surface (T2) of the first optical element (LS1) and the lower surface (T3) of the second optical element (LS2).

## Description

### TECHNICAL FIELD

The present invention relates to an exposure apparatus for exposing a substrate and a device manufacturing method.

Priority is claimed on Japanese Patent Application No. 2004-349730, filed on December 2, 2004, and Japanese Patent Application No. 2005-173339, filed on June 14, 2005, the contents of which are incorporated herein by reference.

### BACKGROUND ART

In the photolithography process which is one manufacturing process for micro devices, such as semiconductor devices and liquid crystal display devices, an exposure apparatus is used which exposes a pattern formed on a mask onto a photosensitive substrate. This exposure apparatus has a mask stage for supporting the mask and a substrate stage for supporting the substrate, and projection-exposes a pattern of the mask onto the substrate via a projection optical system while sequentially moving the mask stage and the substrate stage. In the manufacture of a micro device, in order to increase the density of the device, it is necessary to make the pattern formed on the substrate fine. In order to address this necessity, even higher resolution of the exposure apparatus is desired. As one means for realizing this higher resolution of the exposure apparatus, there is proposed a liquid immersion exposure apparatus as disclosed in the following Patent Document, in which liquid is filled in an optical path space of the exposure light, and the substrate is exposed via the liquid.
[Patent Document 1] PCT International Patent Publication No. WO 99/49504

### DISCLOSURE OF INVENTION

### PROBLEMS TO BE SOLVED BY THE INVENTION

In the immersion exposure apparatus disclosed in the above-described Patent Document 1, an immersion region to which liquid is supplied is formed between the optical element that is closest to the image plane of the projection optical system (hereinafter, the optical element closest to the image plane of the projection optical system is referred to as the "first optical element" as appropriate) from among a plurality of optical elements constituting the projection optical system and the surface of the substrate. In this case, for example, if impurities generated from the substrate are mixed into the liquid in the immersion region and the liquid of the immersion region is contaminated, then the first optical element may be contaminated due to the contaminated liquid in the immersion region. If the first optical element is contaminated, problems such as a decrease in the light transmittance of the first optical element and distribution in the light transmittance occur, thus degrading the exposure accuracy via the projection optical system. To overcome these problems, a structure in which the contaminated first optical element is replaced with, for example, a new one (clean one) is conceivable. On the other hand, in order to increase the image-side numerical aperture of the projection optical system, it is necessary to increase the effective diameter of the first optical element, which inevitably increases the size of the first optical element. To frequently replace such a large-scale first optical element with a new one is difficult and decreases the working efficiency. Furthermore, if the first optical element has refractive power (lens power), to frequently replace the first optical element having such refractive power is not preferable in terms of maintaining the imaging performance of the projection optical system. For this reason, design of an exposure apparatus which is constructed so as to allow exposure light to satisfactorily reach a substrate disposed at adjacent to the image-plane side of the projection optical system without having to frequently replacing the large first optical element having refractive power is demanded. Furthermore, to satisfactorily make exposure light reach the substrate, foreign substances, such as bubbles, need to be prevented from entering the liquid of the immersion region.

In addition, in order to perform immersion exposure processing smoothly and very accurately, it is important to hold the liquid in a desired region successfully and to prevent the liquid from leaking into or scattering over regions other than the desired region. As a result of leakage or scattering of the liquid, for example, the leaking liquid may attach to a device constituting the exposure apparatus, thus possibly causing the device to malfunction or to be damaged. Furthermore, if the device is a measuring instrument for optically measuring, for example, the position of the substrate, the measurement accuracy of the measuring instrument may be degraded due to the leaking liquid. If such a device malfunctions or its measurement accuracy is degraded, the exposure accuracy of the exposure apparatus is also degraded.

Furthermore, in the immersion exposure apparatus, where supplying the liquid to the optical path space and discharging (recovering) the liquid from the optical path space are performed to fill the optical path space with liquid, it is important to smoothly supply and discharge the liquid in order to keep the liquid in the optical path space and various members that are in contact with the liquid clean.

The present invention has been conceived in light of the above-described circumstances, and an object thereof is to provide an exposure apparatus that can prevent the exposure accuracy from decreasing due to, for example, contamination of an optical element, foreign substances (bubbles) existing in liquid, or leakage of the liquid and to provide a device manufacturing method using such an exposure apparatus.

Another object of the present invention is to provide an exposure apparatus that can smoothly perform supplying and discharging of the liquid in an optical path space to expose a substrate with high accuracy and a device manufacturing method using such an exposure apparatus.

### MEANS FOR SOLVING THE PROBLEM

According to a first aspect of the present invention, an exposure apparatus for emitting exposure light onto a substrate via a projection optical system to expose the substrate is provided. In the exposure apparatus, the projection optical system includes a first optical element which is closest to an image plane of the projection optical system and a second optical element which is closest to the image plane next to the first optical element, and the exposure apparatus includes a collection port which is provided at a position higher than a lower surface of the second optical element and which recovers a liquid held in a space between an upper surface of the first optical element and the lower surface of the second optical element.

According to the first aspect of the present invention, even if bubbles (air portion) exist in the liquid held between the upper surface of the first optical element and the lower surface of the second optical element, the bubbles move upward due to the difference in specific gravity between the bubbles and the liquid, and therefore, the collection port provided at a position higher than the lower surface of the second optical element can smoothly collect the bubbles. Therefore, in a state where bubbles in the liquid are removed, exposure processing via the liquid can be performed satisfactorily. Furthermore, the collection port can smoothly collect not only bubbles but also foreign substances having smaller specific gravity than the liquid.

According to a second aspect of the present invention, an exposure apparatus for emitting exposure light onto a substrate via a projection optical system to expose the substrate is provided. In the exposure apparatus, the projection optical system includes a first optical element which is closest to an image plane of the projection optical system and a second optical element which is closest to the image plane next to the first optical element, the exposure apparatus includes a nozzle member which is disposed in an annular shape so as to enclose the second optical element and which has at least one of a liquid supply outlet and a liquid collection port that forms an immersion region of liquid between the first optical element and the second optical element, and the nozzle member includes a holding portion that holds the first optical element by vacuum attraction.

According to the second aspect of the present invention, since the first optical element is held by vacuum attraction by the holding portion provided in the nozzle member, the first optical element can be easily attached/detached (replaced) with respect to the nozzle member. Therefore, even if the first optical element is contaminated, the contaminated first optical element can be replaced with a new one (clean one) smoothly with high workability. Furthermore, since the holding portion is provided in the nozzle member that forms an immersion region of liquid between the first optical element and the second optical element, the number of components in the apparatus can be reduced, the apparatus can be made simple (small), and the cost of the apparatus can be reduced compared with a structure where a vacuum-attraction portion is provided separately from the nozzle member.

According to a third aspect of the present invention, an exposure apparatus for emitting exposure light onto a substrate via a projection optical system to expose the substrate is provided. In the exposure apparatus, the projection optical system includes a first optical element which is closest to an image plane of the projection optical system and a second optical element which is closest to the image plane next to the first optical element, and the exposure apparatus includes an immersion mechanism that forms an immersion region of a liquid in a space between the first optical element and the second optical element; and a detector that detects whether the liquid has leaked from the space.

According to the third aspect of the present invention, since the detector for detecting whether the liquid has leaked from the space between the first optical element and the second optical element is provided, an appropriate measure for preventing the spread of damage due to the leaking liquid can be taken quickly when the detector detects liquid. Therefore, undesired device malfunctions and degradation in exposure accuracy and measurement accuracy can be prevented from occurring.

According to a fourth aspect of the present invention, an exposure apparatus for emitting exposure light onto a substrate via a projection optical system to expose the substrate is provided. The exposure apparatus includes an immersion mechanism that forms an immersion region of a liquid on an upper surface of a predetermined optical element from among a plurality of optical elements constituting the projection optical system, wherein a discharge outlet that discharges the liquid from the immersion region is provided in a supporting member holding the predetermined optical element.

According to the fourth aspect of the present invention, when the first optical element held by the supporting member is to be replaced with a new one (clean one), unwanted leakage or scattering of the liquid during the replacement of the optical element can be prevented from occurring by releasing the holding of the first optical element by the supporting member after the liquid in the immersion region formed on the upper surface of the optical element has been discharged from the discharge outlet. Therefore, undesired device malfunctions and degradation in exposure accuracy and measurement accuracy resulting from scattering liquid can be prevented from occurring.

According to a fifth aspect of the present invention, an exposure apparatus for emitting exposure light onto a substrate via a first optical element to expose the substrate is provided. The exposure apparatus includes a supply outlet that supplies a liquid to an upper surface side of the first optical element such that a predetermined region on the upper surface of the first optical element forms an immersion region, the exposure light passing through the predetermined region; and a frame member which has a support portion that supports an outer circumferential portion of the first optical element and encloses the first optical element, wherein the liquid supplied to the upper surface side of the first optical element is discharged from between the first optical element and the frame member.

According to the fifth aspect of the present invention, the predetermined region on the upper surface of the first optical element can become an immersion region with the liquid supplied from the supply outlet. Furthermore, since the liquid supplied to the upper surface side of the first optical element is discharged from between the first optical element and the frame member, the liquid can be discharged smoothly. Therefore, the liquid in the optical path space and various members in contact with the liquid can be placed in a desired state, and the substrate can be exposed with high accuracy.

According to a sixth aspect of the present invention, a device manufacturing method using the exposure apparatuses of the above-described aspects is provided.

According to the sixth aspect of the present invention, a device can be manufactured using an exposure apparatus that can expose a substrate with high accuracy.

### Advantages

### EFFECTS OF THE INVENTION

According to the present invention, the exposure accuracy can be prevented from decreasing due to, for example, contamination of an optical element, foreign substances (bubbles) existing in liquid, or leakage of the liquid, and a device having desired performance can be provided.

Furthermore, according to the present invention, the substrate can be exposed with high accuracy and a device having desired performance can be manufactured.

### Brief Description of the Drawings

### BRIEF DESCRIPTION OF THE DRAWINGS

FIG. 1 is a schematic block diagram showing an exposure apparatus according to a first embodiment.
FIG. 2 is an enlarged cross-sectional view of the main part of an exposure apparatus.
FIG. 3A is an enlarged view of a second nozzle member.
FIG. 3B is an enlarged view of a second nozzle member.
FIG. 4 is a diagram showing one example of a second nozzle member.
FIG. 5 is a diagram showing a modification of a second nozzle member.
FIG. 6 is a plan top view of a second nozzle member.
FIG. 7 is a diagram for illustrating a recess portion provided on the upper surface of a second nozzle member.
FIG. 8 is a diagram for illustrating the detecting principle of a detector.
FIG. 9 is a diagram for illustrating the detection principle of a detector.
FIG. 10 is a diagram for illustrating a collection port of a second nozzle member.
FIG. 11 is a diagram showing a modification of a collection port of a second nozzle member.
FIG. 12 is a diagram showing a modification of a collection port of a second nozzle member.
FIG. 13 is a diagram showing a modification of a collection port of a second nozzle member.
FIG. 14 is a diagram showing a modification of a collection port of a second nozzle member.
FIG 15 is a diagram for illustrating the liquid recovery operation of an exposure apparatus according to a second embodiment.
FIG. 16 is a diagram for illustrating another embodiment of a liquid recovery operation.
FIG. 17 is a diagram for illustrating another embodiment of a liquid recovery operation.
FIG. 18 is a schematic diagram showing an exposure apparatus according to a third embodiment.
FIG. 19 is a schematic block diagram showing an exposure apparatus according to a first embodiment.
FIG 20 is an enlarged cross-sectional view of the main part for illustrating a second immersion mechanism.
FIG. 21 is an enlarged cross-sectional view of the main part for illustrating a first immersion mechanism.
FIG. 22 is a schematic diagram for illustrating one embodiment of a first optical element and a second nozzle member.
FIG. 23A is a diagram showing a second nozzle member which supports a first optical element and is a top view thereof
FIG 23B is a diagram showing a second nozzle member which supports a first optical element and is a bottom view thereof.
FIG. 24 is a bottom view of a projection optical system.
FIG. 25 is a cross-sectional perspective view for illustrating a second nozzle member.
FIG. 26 is an enlarged cross-sectional view of the main part for illustrating a second nozzle member.
FIG. 27 is an enlarged cross-sectional view of the main part for illustrating a second nozzle member.
FIG. 28 is an enlarged cross-sectional view of the main part for illustrating a second nozzle member.
FIG. 29 is a schematic diagram for illustrating the operation of a second immersion mechanism.
FIG. 30 is a schematic diagram for illustrating the operation of a second immersion mechanism.
FIG. 31 is a schematic diagram for illustrating the operation of a second immersion mechanism.
FIG. 32 is a schematic diagram for illustrating the operation of a second immersion mechanism.
FIG. 33 is a schematic diagram for illustrating another embodiment of a first optical element and a second nozzle member.
FIG. 34 is a schematic diagram for illustrating another embodiment of a first optical element and a second nozzle member.
FIG. 35 is a schematic diagram for illustrating another embodiment of a first optical element and a second nozzle member.
FIG. 36 is a schematic diagram for illustrating another embodiment of a first optical element and a second nozzle member.
FIG. 37 is an enlarged cross-sectional view of the main part showing another embodiment of an exposure apparatus.
FIG. 38 is a flowchart for illustrating one example of a manufacturing process of a micro-device.

### DESCRIPTION OF THE REFERENCE SYMBOLS

1... FIRST IMMERSION MECHANISM, 2... SECOND IMMERSION MECHANISM, 10... FIRST LIQUID SUPPLY MECHANISM, 12... FIRST SUPPLY OUTLET, 20... FIRST LIQUID RECOVERY MECHANISM, 22... FIRST COLLECTION PORT, 30 ... SECOND LIQUID SUPPLY MECHANISM, 32... SECOND SUPPLY OUTLET, 40... SECOND LIQUID RECOVERY MECHANISM, 42... SECOND COLLECTION PORT, 60... SUPPORTING MEMBER, 63... SEALING MEMBER, 64... SEALING MEMBER, 65... THROUGH-HOLE (HOLE), 65'... GAS PORT, 71... FIRST NOZZLE MEMBER, 72... SECOND NOZZLE MEMBER, 72K... LOWER SURFACE, 72J... UPPER SURFACE, 74... DETECTOR (OPTICAL FIBER), 75... RECESS PORTION, 76... SEALING MEMBER, 90... GAS SUPPLY SYSTEM, 100... HOLDING PORTION, EL... EXPOSURE LIGHT, EX... EXPOSURE APPARATUS, F2... FLANGE SURFACE, K1... FIRST SPACE, K2... SECOND SPACE, LQ... LIQUID, LQ1... FIRST LIQUID, LQ2... SECOND LIQUID, LR1... FIRST IMMERSION REGION, LR2... SECOND IMMERSION REGION, LS1... FIRST OPTICAL ELEMENT, LS2... SECOND OPTICAL, ELEMENT, LT1... SIDE SURFACE OF FIRST OPTICAL ELEMENT, LT2... SIDE SURFACE OF SECOND OPTICAL ELEMENT, P... SUBSTRATE, PL... PROJECTION OPTICAL SYSTEM, 201... FIRST IMMERSION MECHANISM, 202... SECOND IMMERSION MECHANISM, 212... SUPPLY OUTLET, 222... COLLECTION PORT, 232... SUPPLY OUTLET, 242... COLLECTION PORT, 251... SUCTION APPARATUS, 252... DISCHARGE OUTLET, 255... COLLECTION MEMBER, 271... FIRST NOZZLE MEMBER, 272... SECOND NOZZLE MEMBER (FRAME MEMBER), 278A... CUT PORTION, 278B... CUT PORTION, 280... SUPPORT PORTION

### BEST MODE FOR CARRYING OUT THE INVENTION

Embodiments according to the present invention will now be described with reference to the drawings. However, the present invention is not limited to those embodiments.

### <First Embodiment>

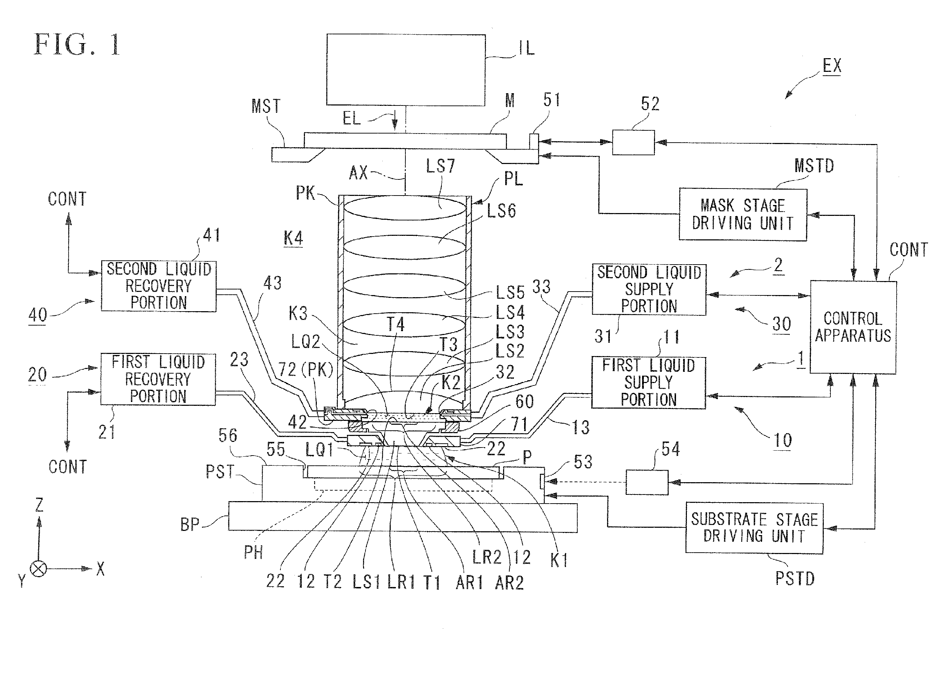

FIG. 1 is a schematic block diagram showing an exposure apparatus EX according to a first embodiment. In FIG. 1, the exposure apparatus EX includes a mask stage MST which is movable while holding a mask M; a substrate stage PST including a substrate holder PH for holding a substrate P; an illumination optical system IL for illuminating the mask M held on the mask stage MST with exposure light EL; a projection optical system PL for projection-exposing a pattern image of the mask M illuminated with the exposure light EL onto the substrate P held on the substrate stage PST; and a control apparatus CONT for comprehensively controlling the operation of the entire exposure apparatus EX.

The exposure apparatus EX of the present embodiment is an immersion exposure apparatus applicable to an immersion method for substantially shortening the exposure wavelength and improving the resolution, and also substantially expanding the depth of focus. The exposure apparatus EX includes a first immersion mechanism 1 for filling a first liquid LQ1 into a first space K1, which is an optical path space of the exposure light EL, between the substrate P and a first optical element LS1 which is disposed closest to the image plane of the projection optical system PL from among a plurality of optical elements LS1 to LS7 constituting the projection optical system PL. The substrate P is disposed adjacent to an image-plane side of the projection optical system PL, and a lower surface T1 of the first optical element LS1 opposes a surface of the substrate P. Above the substrate P (the substrate stage PST), the first immersion mechanism 1 includes an annular first nozzle member 71 which is provided so as to enclose a side surface of the first optical element LS1; a first liquid supply mechanism 10 for supplying the first liquid LQ1 to the first space K1 between the lower surface T1 of the first optical element LS1 and the substrate P via a supply outlet 12 provided on the first nozzle member 71; and a first liquid recovery mechanism 20 for recovering the first liquid LQ1 in the first space K1 via a collection port 22 provided on the first nozzle member 71. The operation of the first immersion mechanism 1 is controlled by the control apparatus CONT.

Furthermore, the exposure apparatus EX includes a second immersion mechanism 2 for filling a second liquid LQ2 into a second space K2, which is an optical path space of the exposure light EL, between the first optical element LS1 and the second optical element LS2 which is disposed closest to the image plane of the projection optical system PL next to the first optical element LS1. The second optical element LS2 is disposed above the first optical element LS1, and an upper surface T2 of the first optical element LS1 is disposed so as to oppose a lower surface T3 of the second optical element LS2. Above the first optical element LS1, the second immersion mechanism 2 includes an annular second nozzle member 72 which is disposed so as to enclose a side surface of the second optical element LS2; a second liquid supply mechanism 30 for supplying the second liquid LQ2 to the second space K2 between the lower surface T3 of the second optical element LS2 and the upper surface T2 of the first optical element LS1 via a supply outlet 32 provided on the second nozzle member 72; and a second liquid recovery mechanism 40 for recovering the second liquid LQ2 of the second space K2 via a collection port 42 provided on the second nozzle member 72. The operation of the second immersion mechanism 2 is controlled by the control apparatus CONT.

In this embodiment, the first space K1 between the first optical element LS1 and the substrate P is independent of the second space K2 between the first optical element LS1 and the second optical element LS2. The control apparatus CONT can perform supply operation and recovery operation of the first liquid LQ1 with respect to the first space K1 by the first immersion mechanism 1 and supply operation and recovery operation of the second liquid LQ2 with respect to the second space K2 by the second immersion mechanism 2 independently of each other, and comings or goings of the liquids (LQ1 and LQ2) from one of the first space K1 and the second space K2 to the other do not occur.

At least while a pattern image of the mask M is being transferred onto the substrate P, the exposure apparatus EX forms a first immersion region LR1 by filling the first liquid LQ1 between the first optical element LS1 and the substrate P disposed adjacent to the image-plane side using the first immersion mechanism 1 and forms a second immersion region LR2 by filling the second liquid LQ2 between the first optical element LS1 and the second optical element LS2 using the second immersion mechanism 2. In this embodiment, the exposure apparatus EX adopts a local liquid immersion method for locally forming the first immersion region LR1 which is greater than a projection region AR1 and smaller than the substrate P in a region of one part of the substrate P which includes the projection region AR1 of the projection optical system PL. In addition, in this embodiment, the exposure apparatus EX forms the second immersion region LR2 of the second liquid LQ2 in a region that includes a region AR2 through which the exposure light EL passes on the upper surface T2 of the first optical element LS1. In other words, the first immersion mechanism 201 supplies a liquid LQ to the surface of the substrate P from the supply outlet 12 of the first nozzle member 71 such that the projection region AR1 that is irradiated with the exposure light EL on the surface of the substrate P forms the first immersion region LR1. Furthermore, in this embodiment, the exposure apparatus EX forms the second immersion region LR2 of the liquid LQ in a region that includes the predetermined region AR2 through which the exposure light EL passes on the upper surface T2 of the first optical element LS1. In other words, the second immersion mechanism 2 supplies the liquid LQ to the upper surface T2 of the first optical element LS1 from the supply outlet 32 of the second nozzle member 72 such that the predetermined region AR2 through which the exposure light EL passes on the upper surface T2 of the first optical element LS1 forms the second immersion region LR2. The exposure apparatus EX projection-exposes a pattern of the mask M onto the substrate P via the projection optical system PL including the first and second optical elements LS1 and LS2, the second liquid LQ2 in the second immersion region LR2, and the first liquid LQ1 in the first immersion region LR1 by irradiating the substrate P with the exposure light EL that has passed through the mask M.

In this embodiment, the first immersion region LR1 is described as being formed on the substrate P in some cases. However, the first immersion region LR1 can also be formed on an object disposed at a position facing the first optical element LS1 adjacent to the image-plane side of the projection optical system PL, for example, on the upper surface of the substrate stage PST.

The present embodiment is described by way of an example where a scanning type exposure apparatus (a so called scanning stepper) which exposes the pattern formed on the mask M onto the substrate P while the mask M and the substrate P are simultaneously moved in a scanning direction is used as the exposure apparatus EX. In the following description, the synchronous movement direction (the scanning direction) of the mask M and the substrate P in a horizontal plane is made the X axis direction, the direction perpendicular to the X axis direction in a horizontal plane is made the Y axis direction (the non-scanning direction), and the direction that is perpendicular to the X axis and Y axis directions that coincides with an optical axis AX of the projection optical system PL is made the Z axis direction. Furthermore, rotation (inclination) directions about the X axis, the Y axis, and the Z axis are made the θX, the θY and the θZ directions respectively. The "substrate" includes a sensitive material (photoresist) which is coated on a base material of a semiconductor wafer or the like, and the "mask" includes a reticle formed with a device pattern which is size reduction projected onto the substrate.

The illumination optical system IL has a light source for exposure, an optical integrator for making the luminance distribution of the exposure light EL emitted from the exposure light source uniform, a condenser lens for condensing the exposure light EL from the optical integrator, a relay lens system, and a field stop for setting an illumination area on the mask M formed by the exposure light EL, etc. A specified illumination area on the mask M is illuminated by the illumination optical system IL with the exposure light EL having a uniform luminance distribution. For the exposure light EL radiated from the illumination optical system IL, for example emission lines (g line, h line, i line), emitted for example from a mercury lamp, deep ultraviolet beams (DUV light beams) such as the KrF excimer laser beam (wavelength: 248 nm), and vacuum ultraviolet light beams (VUV light beams) such as the ArF excimer laser beam (wavelength: 193 nm) and the F₂ laser beam (wavelength: 157 nm), may be used. In this embodiment, the ArF excimer laser beam is used.

In this embodiment, pure water is used as the first liquid LQ1 supplied from the first liquid supply mechanism 10 and the second liquid LQ2 supplied from the second liquid supply mechanism 30. In short, in this embodiment, the first liquid LQ1 and the second liquid LQ2 are the same liquids. Pure water can transmit not only an ArF excimer laser beam but also, for example, emission lines (g line, h line, or i line) emitted from a mercury lamp and deep ultraviolet light (DUV light) such as a KrF excimer laser beam (wavelength: 248 nm).

The mask stage MST can move while holding the mask M. The mask stage MST holds the mask M by vacuum attraction (or electrostatic attraction). The mask stage MST is two dimensionally movable in a plane orthogonal to the optical axis AX of the projection optical system PL, that is, in the XY plane and is finely rotatable in the θZ direction while holding the mask M by driving a mask stage driving unit MSTD including, for example, a linear motor which is controlled by the control apparatus CONT.

A movable mirror 51 is provided on the mask stage MST. Furthermore, a laser interferometer 52 is provided at a position opposing the movable mirror 51. The tow-dimensional positions and the rotation angle in the θZ direction (including the rotation angles in the θX and θY directions in some cases) of the mask M on the mask stage MST are measured in real time by the laser interferometer 52. Measurement results of the laser interferometer 52 are output to the control apparatus CONT. The control apparatus CONT drives the mask stage driving unit MSTD based on the measurement results from the laser interferometer 52 so as to control the position of the mask M held on the mask stage MST.

The projection optical system PL projection-exposes a pattern of the mask M onto the substrate P with a predetermined projection magnification P and is constituted by the plurality of optical elements LS1 to LS7, including the first optical element LS1 disposed at a position closest to the image plane of the projection optical system PL. The first optical element LS1 of the plurality of optical elements LS1 to LS7 is held by a supporting member (lens cell) 60, and the supporting member 60 is connected to the second nozzle member 72. Furthermore, the plurality of optical elements LS2 to LS7 other than the first optical element LS1 are supported by a barrel PK. In addition, the second nozzle member 72 is connected to a lower-end portion of the barrel PK, and in this embodiment, the second nozzle member 72 and the barrel PK are substantially integral. In other words, the second nozzle member 72 constitutes part of the barrel PK. Alternatively, the second nozzle member 72 may be a member separated from the barrel PK so as to support the second nozzle member 72 by a predetermined support mechanism different from the barrel PK. In this embodiment, the projection optical system PL is a reduction system having a projection magnification β of, for example, 1/4, 1/5, or 1/8. Alternatively, the projection optical system PL may be an equal system or a magnifying system. Furthermore, in the projection optical system PL, including the first optical element LS1, image-forming characteristics, such as aberration, fall within predetermined tolerance ranges. In addition, the internal space in the barrel PK of the projection optical system PL is substantially sealed and is maintained as a predetermined gas environment by a gas replacement apparatus (not shown in the figure). In this embodiment, the space above the second optical element LS2 (the space adjacent to the mask) in the internal space of the barrel PK is filled with an inert gas such as helium, argon, or nitrogen. Alternatively, the internal space of the barrel PK may be filled with dry air.

As described above, the substrate stage PST includes the substrate holder PH for holding the substrate P and is movable while holding the substrate P in the substrate holder PH. The substrate holder PH holds the substrate P by, for example, vacuum attraction. The substrate stage PST is two dimensionally movable in the XY plane and is finely rotatable in the θZ direction above a base member BP while holding the substrate P via the substrate holder PH by driving a substrate stage driving unit PSTD including, for example, a linear motor which is controlled by the control apparatus CONT. Furthermore, the substrate stage PST can also be moved in the Z axial direction, the θX direction, and the θY direction. Therefore, the surface of the substrate P held in the substrate stage PST is movable in a direction of six degrees of freedom of: the X axis, Y axis, Z axis, θX, θY and θZ directions.

A movable mirror 53 is provided on a side surface of the substrate stage PST. In addition, a laser interferometer 54 is provided at a position opposing the movable mirror 53. The tow-dimensional positions and the rotation angles of the substrate P on the substrate stage PST are measured in real time by the laser interferometer 54. Furthermore, although not shown in the figure, the exposure apparatus EX includes a focus leveling detection system for detecting positional information about the surface of the substrate P held on the substrate stage PST. For the focus leveling detection system, for example, an oblique incidence method for emitting detection light onto the surface of the substrate P from an oblique direction or a method using a capacitance sensor can be employed. The focus leveling detection system detects positional information about the substrate P surface in the Z axial direction and inclination information about the substrate P in the θX and θY directions via the first liquid LQ1 or not via the first liquid LQ1.

The measurement results of the laser interferometer 54 are output to the control apparatus CONT. The detection results of the focus leveling detection system are also output to the control apparatus CONT. The control apparatus CONT controls the focus position (Z position) and the inclination angles (θX and θY) of the substrate P by driving the substrate stage driving unit PSTD and based on the detection results of the focus leveling detection system to adjust the positional relationship between the surface of the substrate P and the image plane formed via the projection optical system PL and the first liquid LQ1. Furthermore, the control apparatus CONT performs position-control of the substrate P in the X axial direction, Y axial direction, and OZ direction based on the measurement results of the laser interferometer 54.

A recess portion 55 is provided on the substrate stage PST, and the substrate holder PH for holding the substrate P is disposed in the recess portion 55. An upper surface 56, except the recess portion 55, of the substrate stage PST is a flat surface (flat portion) with a height substantially the same (same surface) as the surface of the substrate P held in the substrate holder PH. The upper surface 56 with a height substantially the same as the substrate P surface is provided around the substrate P. Therefore, even when an edge area of the substrate P is to be subjected to immersion exposure, the immersion region LR1 can be formed satisfactorily while holding the first liquid LQ1 adjacent to the image-plane side of the projection optical system PL since there is substantially no step portion outside the edge portion of the substrate P. Furthermore, although there is a gap about 0.1 to 1.0 mm in size between the edge portion of the substrate P and the flat surface (upper surface) 56 provided around the substrate P, the surface tension of the first liquid LQ1 substantially prevents the first liquid LQ1 from flowing into the gap. Also when a vicinity of a peripheral region of the substrate P is to be exposed, the first liquid LQ1 can be held on the upper surface 56 below the projection optical system PL. There may be a step between an upper surface 297 of the substrate stage PST and the surface of the substrate P held in the substrate holder PH as long as the liquid LQ can be continuously held in the first space K1.

The first liquid supply mechanism 10 of the first immersion mechanism 1 supplies the first liquid LQ1 to the first space K1 between the first optical element LS1 of the projection optical system PL and the substrate P and includes a first liquid supply portion 11 which can send the first liquid LQ1 and a first supply pipe 13 having one end portion thereof connected to the first liquid supply portion 11. The other end portion of the first supply pipe 13 is connected to the first nozzle member 71. The first liquid supply portion 11 includes a tank which stores the first liquid LQ1; a pressurizing pump; a temperature-regulating apparatus for adjusting the temperature of the first liquid LQ1 to be supplied; a filter unit for removing foreign substances (including bubbles) in the first liquid LQ1; and so forth. The operation of the first liquid supply portion 11 is controlled by the control apparatus CONT.

The first liquid recovery mechanism 20 of the first immersion mechanism 1 recovers the first liquid LQ1 on the image-plane side of the projection optical system PL and includes a first liquid recovery portion 21 which can recover the first liquid LQ1; and a first recovery pipe 23 having one end portion thereof connected to the first liquid recovery portion 21. The other end portion of the first recovery pipe 23 is connected to the first nozzle member 71. The first liquid recovery portion 21 includes a vacuum system (suction apparatus) such as a vacuum pump; a gas-liquid separator for separating a gas from the recovered first liquid LQ1; a tank which stores the recovered first liquid LQ1; and so forth. The operation of the first liquid recovery portion 21 is controlled by the control apparatus CONT.

The second liquid supply mechanism 30 of the second immersion mechanism 2 supplies the second liquid LQ2 to the second space K2 between the second optical element LS2 and the first optical element LS1 of the projection optical system PL and includes a second liquid supply portion 31 which can send the second liquid LQ2; and a second supply pipe 33 having one end portion thereof connected to the second liquid supply portion 31. The other end portion of the second supply pipe 33 is connected to the second nozzle member 72. The second liquid supply portion 31 includes a tank which stores the second liquid LQ2; a pressurizing pump; a temperature-regulating apparatus for adjusting the temperature of the second liquid LQ2 to be supplied; a filter unit for removing foreign substances (including bubbles) in the second liquid LQ2; and so forth. The operation of the second liquid supply portion 31 is controlled by the control apparatus CONT.

The second liquid recovery mechanism 40 of the second immersion mechanism 2 recovers the second liquid LQ2 in the second space K2 between the second optical element LS2 and the first optical element LS1 of the projection optical system PL and includes a second liquid recovery portion 41 which can recover the second liquid LQ2; and a second recovery pipe 43 having one end portion thereof connected to the second liquid recovery portion 41. The other end portion of the second recovery pipe 43 is connected to the second nozzle member 72. The second liquid recovery portion 41 includes a vacuum system (suction apparatus) such as a vacuum pump; a gas-liquid separator for separating a gas from the recovered second liquid LQ2; a tank which stores the recovered second liquid LQ2; and so forth. The operation of the second liquid recovery portion 41 is controlled by the control apparatus CONT.

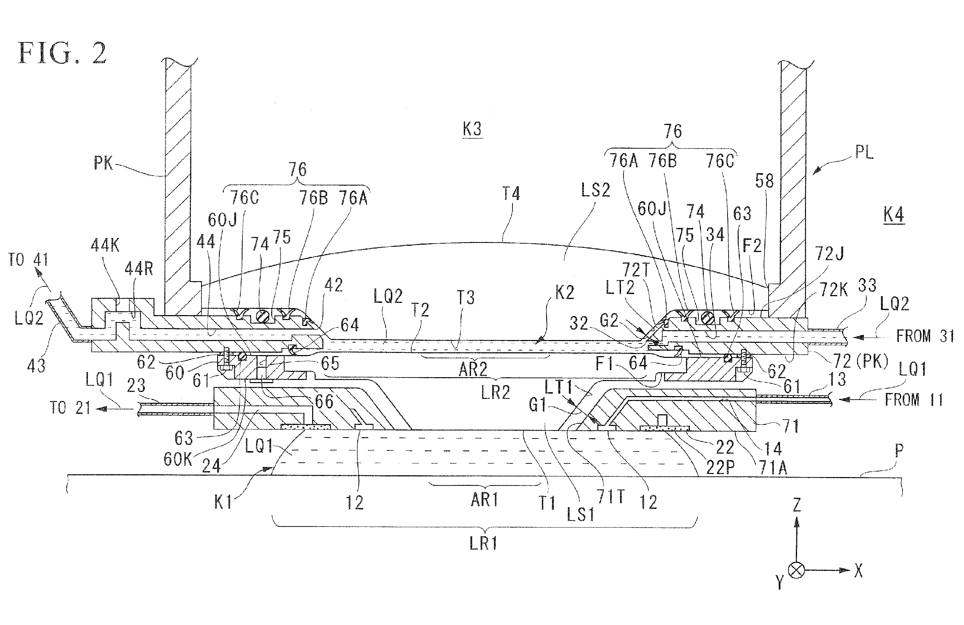

FIG. 2 is a sectional side view of a vicinity of the first and second optical elements LS1 and LS2. The first optical element LS1 is a plane-parallel plate which has no refractive power and can transmit the exposure light EL, and the lower surface T1 and the upper surface T2 are parallel. In the projection optical system PL, including the first optical element LS1, image-forming characteristics, such as aberration, fall within predetermined tolerance ranges. The outer diameter of the upper surface T2 is larger than the outer diameter of the lower surface T1, and the first optical element LS1 has a flange portion F1. The flange portion F1 of the first optical element LS1 is held by the supporting member (lens cell) 60. The lower surface T1 and the upper surface T2 of the first optical element LS1 held by the supporting member 60 are substantially parallel to the XY plane. Since the surface of the substrate P supported by the substrate stage PST and the XY plane are substantially parallel, the lower surface T1 and the upper surface T2 are substantially parallel to the surface of the substrate P supported by the substrate stage PST.

The supporting member 60 holding the first optical element LS 1 is connected to the second nozzle member 72. The supporting member 60 and the second nozzle member 72 are connected to each other with a plurality of bolts 61. Furthermore, the holding of the first optical element LS1 by the supporting member 60 is released by releasing the connection by the bolts 61. In short, the first optical element LS1 is provided so as to be easily detachable (replaceable).

Furthermore, a spacer member 62 is disposed between a lower surface 72K of the second nozzle member 72 and an upper surface 60J of the supporting member 60. The lower surface 72K of the second nozzle member 72 opposes a region that is different from the region through which the exposure light EL passes on the upper surface T2 of the first optical element LS1. The spacer member 62 includes washer members corresponding to the bolts 61 and has a function as an adjustment mechanism for adjusting the positional relationship between the second nozzle member 72 (the barrel PK) and the supporting member 60 and, eventually, the positional relationship between the second optical element LS2 held by the barrel PK and the first optical element LS1 held by the supporting member 60. Here, the positional relationship between the second optical element LS2 and the first optical element LS1 includes the relative distance or the relative inclination between the lower surface T3 of the second optical element LS2 and the upper surface T2 of the first optical element LS1. Spacer members 62 are supported so as to be in contact with the upper surface 60J of the supporting member 60 and are disposed at predetermined angular intervals. The positional relationship can be adjusted by changing, as appropriate, the thickness of the spacer member 62 to be used or changing, as appropriate, the number of layers of the spacer member 62. The second nozzle member 72 and the supporting member 60 are secured with the bolts 61 such that the spacer member 62 is disposed between the lower surface 72K of the second nozzle member 72 and the upper surface 60J of the supporting member 60.

The second optical element LS2 is an optical element having refractive power (lens power) and includes the flat lower surface T3 and an upper surface T4 which is formed in a convex shape protruding towards the object-surface side (the mask M side) to exhibit positive refractive power. The outer diameter of the upper surface T4 is larger than the outer diameter of the lower surface T3, and the second optical element LS2 has a flange surface F2. An edge portion of the flange surface F2 of the second optical element LS2 is supported by a support portion 58 provided at a lower-end portion of the barrel PK. The second optical element LS2 (and the optical elements LS3 to LS7) are held by the barrel PK.

The lower surface T3 of the second optical element LS2 supported by the support portion 58 and the upper surface T2 of the first optical element LS1 held by the supporting member 60 are substantially parallel. In addition, since the upper surface T4 of the second optical element LS2 has positive refractive power as described above, the reflection loss of light (the exposure light EL) incident upon the upper surface T4 is reduced, which eventually ensures a large image-side numerical aperture. Furthermore, the second optical element LS2 having refractive power (lens power) is supported in a satisfactorily positioned state by the support portion 58 of the barrel PK. In addition, in this embodiment, the outer diameter of the lower surface T3 of the second optical element LS2 opposing the first optical element LS 1 is formed to be smaller than the outer diameter of the upper surface T2 of the first optical element LS1.

The exposure light EL emitted from the illumination optical system IL passes through each of the plurality of optical elements LS7 to LS3, a predetermined region on the upper surface T4 of the second optical element LS2, and a predetermined region on the lower surface T3 and is incident upon the second immersion region LR2. The exposure light EL that has passed through the second immersion region LR2 passes through a predetermined region on the upper surface T2 and a predetermined region on the lower surface T1 of the first optical element LS1, is incident upon the first immersion region LR1, and reaches the substrate P.

The first nozzle member 71 constitutes part of the first immersion mechanism 1 and is an annular shape member provided so as to enclose a side surface 71T of the first optical element LS1. The first nozzle member 71 can be formed of, for example, titanium, stainless steel (e.g., SUS316), duralumin, and an alloy including these metals (e.g., titanium alloy), quartz, glass-ceramic (e.g., Zerodur (registered trademark)), Si (silicon) crystal, an amorphous material. The first nozzle member 71 is disposed adjacent to the image-plane-side end portion of the projection optical system PL and is provided so as to enclose the perimeter of the first optical element LS1 of the projection optical system PL between the flange portion F1 of the first optical element LS1 and the substrate P (the substrate stage PST). The lower surface T1 of the first optical element LS1 held by the supporting member 60 and a lower surface 71A of the first nozzle member 71 are substantially the same surface.

A predetermined gap G1 is provided between an inside face 71T of the first nozzle member 71 and a side surface LT1 of the first optical element LS 1. The gap G I vibrationally isolates the projection optical system PL (the first optical element LS1) from the first nozzle member 71. By doing so, vibration generated in the first nozzle member 71 is prevented from being transmitted directly to the projection optical system PL. The inside face 71T of the first nozzle member 71 is liquid-repellent (water-repellent) to the first liquid LQ 1, and the first liquid LQ1 is prevented from entering the gap G1 between the side surface LT1 of the first optical element LS1 and the inside face 71T of the first nozzle member 71. Water-repellency treatment for imparting water-repellency will be described later.

The liquid supply outlet 12 for supplying the first liquid LQ1 and the liquid collection port 22 for recovering the first liquid LQ1 are formed on the lower surface 71A of the first nozzle member 71. In the following description, the liquid supply outlet 12 of the first immersion mechanism 1 is referred to as the first supply outlet 12, and the liquid collection port 22 of the first immersion mechanism 1 is referred to as the first collection port 22 as appropriate.

Above the substrate P supported on the substrate stage PST, the first supply outlet 12 is provided so as to oppose the substrate P surface. The first supply outlet 12 and the substrate P surface are separated by a predetermined distance. The first supply outlet 12 is disposed so as to enclose the projection region AR1 of the projection optical system PL that is irradiated with the exposure light EL. In this embodiment, a plurality ofthe first supply outlets 12 is formed on the lower surface 71A of the first nozzle member 71 so as to enclose the projection region AR1.

Above the substrate P supported on the substrate stage PST, the first collection port 22 is provided so as to oppose the substrate P surface. The first collection port 22 and the substrate P surface are separated by a predetermined distance. The first collection port 22 is provided on the outside of the first supply outlet 12 with respect to the projection region AR1 of the projection optical system PL and is formed in an annular slit shape so as to enclose the first supply outlet 12 and the projection region AR1 irradiated with the exposure light EL.

A porous member 22P having a plurality of holes is disposed in the first collection port 22 so as to cover the first collection port 22. The porous member 22P is formed of a mesh member having a plurality of holes. The porous member 22P can be formed by performing the process of making holes in a plate member, which is to serve as a base material of the porous member, formed of, for example, quartz, titanium, stainless steel (e.g., SUS316), and ceramics, or a hydrophilic material. Furthermore, the porous member 22P may be subjected to surface treatment for suppressing mixture of impurities into the first liquid LQ1 or surface treatment for enhancing the lyophilicity. Such surface treatment includes treatment for depositing chromium oxide onto the porous member 22P, for example, "GOLDEP" treatment or "GOLDEP WHITE" treatment by Kobelco Eco-Solutions Co,. LTD. By applying such surface treatment, unwanted mixture of impurities into the first liquid LQ1 from the porous member 22P can be prevented. In addition, the first and second nozzle members 71 and 72 may be subjected to the above-described surface treatment.

A first supply passage 14, which is an internal passage, for connecting the plurality of first supply outlets 12 to the supply pipe 13 is provided inside the first nozzle member 71. The first supply passage 14 formed in the first nozzle member 71 branches at an intermediate point so as to be connected to each of the plurality of first supply outlets 12. Furthermore, a first recovery passage 24, which is an internal passage, for connecting the annular first collection port 22 and the recovery pipe 23 is provided inside the first nozzle member 71. The first recovery passage 24 is formed in an annular shape so as to correspond to the annular first collection port 22 and includes an annular passage connected to the collection port 22 and a manifold passage connecting part of the annular passage and the recovery pipe 23.

When the immersion region LR1 for the first liquid LQ1 is to be formed, the control apparatus CONT performs supply and recovery of the first liquid LQ1 with respect to the substrate P using the first liquid supply mechanism 10 and the first liquid recovery mechanism 20 of the first immersion mechanism 1. When the first liquid LQ1 is to be supplied onto the substrate P, the control apparatus CONT sends the first liquid LQ1 from the first liquid supply portion 11 to supply the first liquid LQ1 onto the substrate P from the first supply outlet 12 provided above the substrate P via the supply pipe 13 and the first supply passage 14 of the first nozzle member 71. When the first liquid LQ1 on the substrate P is to be recovered, the control apparatus CONT drives the first liquid recovery portion 21. As a result of the first liquid recovery portion 21 being driven, the first liquid LQ1 on the substrate P flows into the first recovery passage 24 of the first nozzle member 71 via the first collection port 22 provided above the substrate P and is recovered by the first liquid recovery portion 21 via the recovery pipe 23. The first liquid LQ1 is held between the lower surface 71A of the first nozzle member 71 and the lower surface T1 of the optical element LS1 of the projection optical system PL and the substrate P surface to form the first immersion region LR1.

The second nozzle member 72 constitutes part of the second immersion mechanism 2 and is an annular shape member provided so as to enclose a side surface 72T of the second optical element LS2 between the flange surface F2 of the second optical element LS2 and the first optical element LS 1. The flange surface F2 of the second optical element LS2 opposes an upper surface 72J of the second nozzle member 72. The second nozzle member 72 can also be formed of the same material as that of the above-described first nozzle member. The second nozzle member 72 is connected to a lower-end portion of the barrel PK and is supported by the barrel PK. As described above, the second nozzle member 72 and the barrel PK are substantially integral, and the second nozzle member 72 constitutes part of the barrel PK. A predetermined gap G2 is provided between the inside face 72T of the second nozzle member 72 and a side surface LT2 of the second optical element LS2.

The liquid supply outlet 32 for supplying the second liquid LQ2 and the liquid collection port 42 for recovering the second liquid LQ2 are formed in the second nozzle member 72. In the following description, the liquid supply outlet 32 provided in the second nozzle member 72 of the second immersion mechanism 2 is referred to as the second supply outlet 32, and the liquid collection port 42 of the second immersion mechanism 2 is referred to as the second collection port 42 as appropriate.

The second supply outlet 32 is provided at a position facing the second space K2 on the inside face 72T of the second nozzle member 72. The second collection port 42 is provided on the inside face 72T, which opposes the side surface LT2 of the second optical element LS2, in the second nozzle member 72. The second collection port 42 is provided at a position higher than the lower surface T3 of the second optical element LS2. In this embodiment, the second collection port 42 is oriented sideward. However, the second collection port 42 may be oriented, for example, obliquely downwards or upwards.

Furthermore, a second supply passage 34, which is an internal passage, for connecting the second supply outlet 32 and the supply pipe 33 is provided inside the second nozzle member 72. In addition, a second recovery passage 44, which is an internal passage, for connecting the second collection port 42 and the recovery pipe 43 is provided inside the second nozzle member 72.

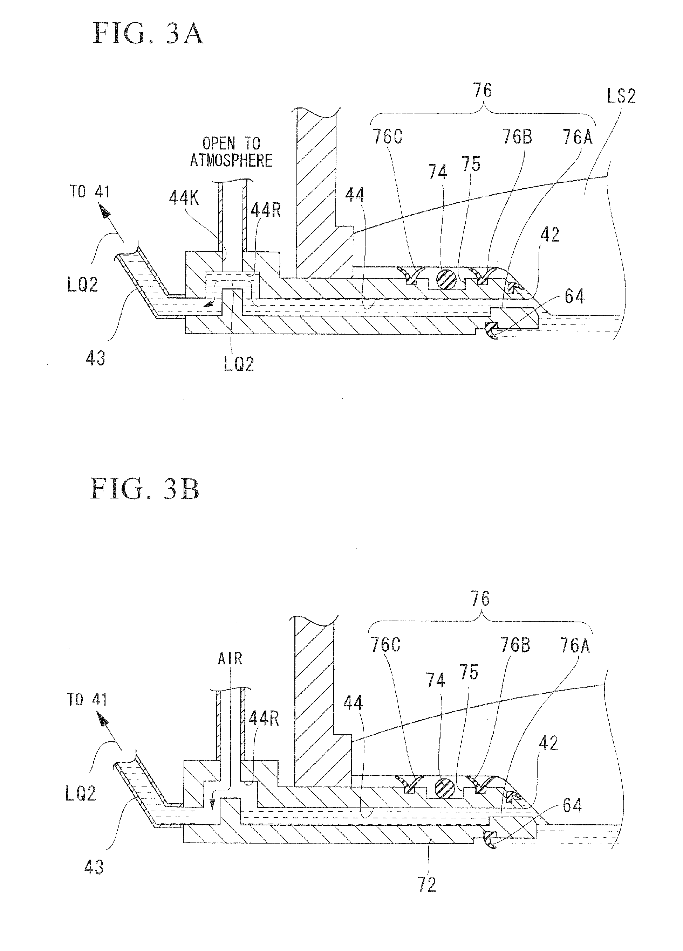

FIG. 3A is a diagram schematically showing a vicinity of the second recovery passage 44. As shown in FIG 3A, a bent portion 44R which is bent upwards with respect to the second collection port 42 is provided in part of the second recovery passage 44 formed in the second nozzle member 72. Furthermore, a joint portion between the second recovery passage 44 and the second recovery pipe 43 is provided below the bent portion 44R. More specifically, the second liquid LQ2 recovered from the second collection port 42 flows substantially horizontally, upwards, and downwards and then flows into the second recovery pipe 43. A hole 44K for communicating between the inside and the outside of the second recovery passage 44 is provided above the bent portion 44R. Due to the hole 44K, the second recovery passage 44 is made open to the atmosphere. As a result of the hole 44K communicating with the atmosphere being provided, the second space K2 (the space inside the barrel PK) can be prevented from exhibiting negative pressure even when the second space K2 is sucked by the second liquid recovery portion 41. More specifically, when the pressure of the second space K2 and the second recovery passage 44 connected to the second space K2 decreases as a result of suction operation by the second liquid recovery portion 41, gas flows into the second recovery passage 44 via the hole 44K, as shown in FIG. 3B. Therefore, the second space K2 and the second recovery passage 44 connected to the second space K2 can be prevented from exhibiting negative pressure. In this manner, the second space K2 can be prevented from exhibiting negative pressure by achieving an overflow structure where the bent portion 44R having the hole 44K is provided at a position higher than the second collection port 42 and the joint portion between the second recovery passage 44 and the second recovery pipe 43. The above-described porous member 22P may be attached to the hole 44K communicating with the atmosphere. By attaching this porous member, the occurrence of heat of vaporization during the suction operation by the second liquid recovery portion 41 can be suppressed.

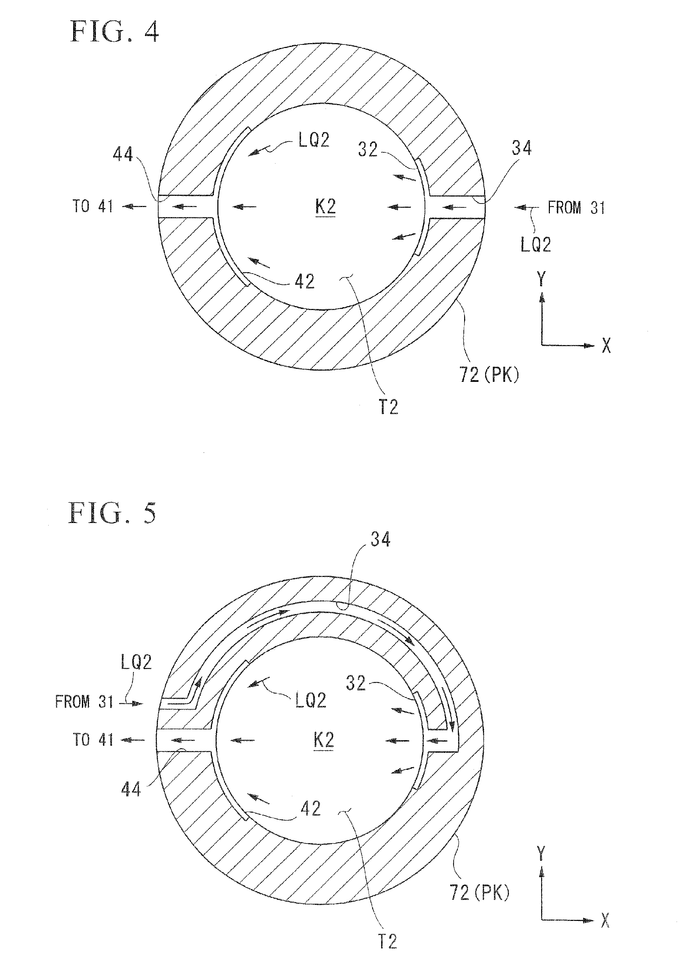

FIG. 4 is a cross-sectional top view of the second nozzle member 72. As shown in FIG. 4, in this embodiment, the second supply outlet 32 is provided on the +X side of the second space K2, and the second collection port 42 is provided on the -X side of the second space K2. The second supply outlet 32 is shaped like a slit having a predetermined width, and the second collection port 42 is formed to be the same size as or larger than the second supply outlet 32. Liquid recovery can be performed smoothly by forming the second collection port 42 to be larger than the second supply outlet 32. As with the first collection port 22, a porous member may be provided in the second collection port 42.

The numbers and arrangements of second supply outlets 32 and second collection ports 42, the numbers and arrangements of second supply passages 34 and second recovery passages 44, and so forth can be set freely. For example, the second supply outlet 32 may be formed at each of a plurality of predetermined positions of the second nozzle member 72. Similarly, the second collection port 42 may be formed at each of a plurality of predetermined positions of the second nozzle member 72. Furthermore, as shown in, for example, FIG. 5, the length of the second supply passage 34 may be made relatively larger by forming the second supply passage 34 along the circumferential direction of the second nozzle member 72. By doing so, the second liquid LQ2 to be supplied to the second space K2 is supplied to the second space K2 via the second supply outlet 32 after the second liquid LQ2 has been adjusted to substantially the same temperature as the temperature of the second nozzle member 72 and eventually, the temperature of the barrel PK connected to the second nozzle member 72. In FIG. 5, the second supply passage 34 is formed only half around the circumference in the circumferential direction of the second nozzle member 72. However, the second supply passage 34 may be formed all around the circumference or may be formed helically, for example.

When the immersion region LR2 for the second liquid LQ2 is to be formed, the control apparatus CONT performs supply and recovery of the second liquid LQ2 with respect to the second space K2 using the second liquid supply mechanism 30 and the second liquid recovery mechanism 40 of the second immersion mechanism 2. When the second liquid LQ2 is to be supplied to the second space K2, the control apparatus CONT sends the second liquid LQ2 from the second liquid supply portion 31 to supply the second liquid LQ2 to the second space K2 from the second supply outlet 32 via the supply pipe 33 and the second supply passage 34 of the second nozzle member 72. When the second liquid LQ2 in the second space K2 is to be recovered, the control apparatus CONT drives the second liquid recovery portion 41. As a result of the second liquid recovery portion 41 being driven, the second liquid LQ2 in the second space K2 flows into the second recovery passage 44 of the second nozzle member 72 via the second collection port 42 provided at a position higher than the lower surface T3 of the second optical element LS2 and is recovered by the second liquid recovery portion 41 via the recovery pipe 43. The second liquid LQ2 is held in the second space K2 between the lower surface T3 of the second optical element LS2 and the upper surface T2 of the first optical element LS1 to form the second immersion region LR2.

Returning to FIG. 2, a sealing member 64 is provided between the upper surface T2 of the first optical element LS1 and the lower surface 72K of the second nozzle member 72. Furthermore, a sealing member 63 is provided between the upper surface 60J of the supporting member 60 and the lower surface 72K of the second nozzle member 72. The sealing members 63 and 64 suppress circulation of the second liquid LQ2 between the second space K2 and the outer space thereof and, in particular, prevent the second liquid LQ2 held in the second space K2 from leaking to the outer space. The sealing members 63 and 64 mainly prevent the second liquid LQ2 held in the second space K2 from leaking to a fourth space K4 outside the barrel PK. The sealing member 64 may be provided between the upper surface 60J of the supporting member 60 and the lower surface 72K of the second nozzle member 72.

The sealing members 63 and 64 have to control circulation of the second liquid LQ2 and may be formed of, for example, O-rings, V-rings, C-rings, or water-repellent ring-shaped sheet members. In this embodiment, the scaling member 64 is a V-ring, and the sealing member 63 is an O-ring. Alternatively, The sealing member 64 may be omitted, and circulation of the second liquid LQ2 may be suppressed through water-repellency treatment, which will be described later.

Furthermore, a sealing member 76A is provided in the gap G2 between the inside face 72T of the second nozzle member 72 and the side surface LT2 of the second optical element LS2, and sealing members 76B and 76C are provided between the upper surface 72J of the second nozzle member 72 and the flange surface F2 of the second optical element LS2 facing the upper surface 72J. The sealing member 76B and the sealing member 76C are provided concentrically so as to have their centers at the optical axis of the second optical element LS2. These sealing members 76 (76A, 76B, and 76C) also suppress circulation of the second liquid LQ2 between the second space K2 and the outer space thereof and prevent the second liquid LQ2 held in the second space K2 from leaking to the outer space. The sealing members 76 mainly prevent the second liquid LQ2 held in the second space K2 from leaking into a third space K3 on the upper surface T4 side of the second optical element LS2 (the space inside the barrel PK) and also from leaking into the fourth space K4 outside the barrel PK. If there is no danger of the second liquid LQ2 held in the second space K2 leaking into the third space K3, these sealing members 76 can be omitted.

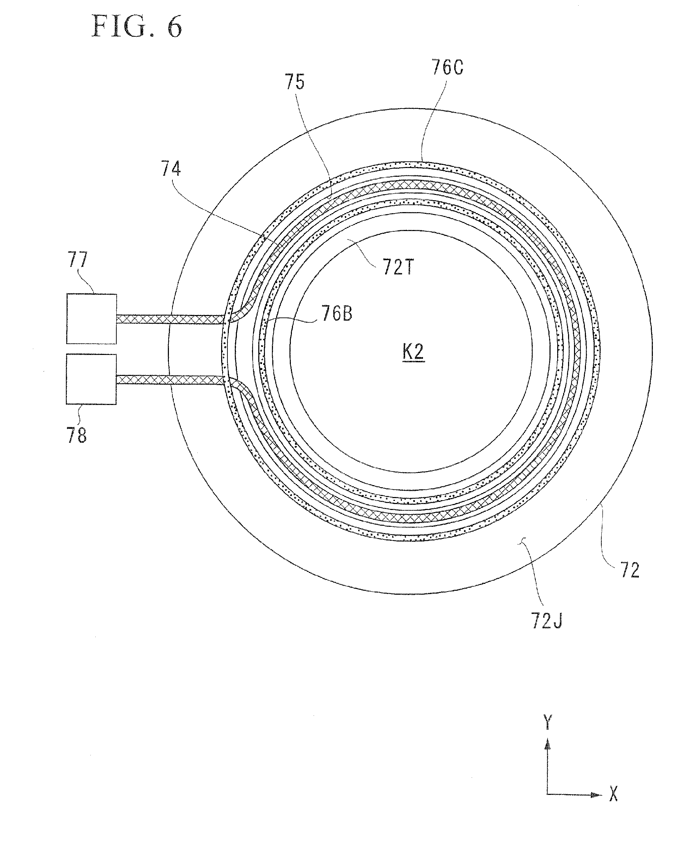

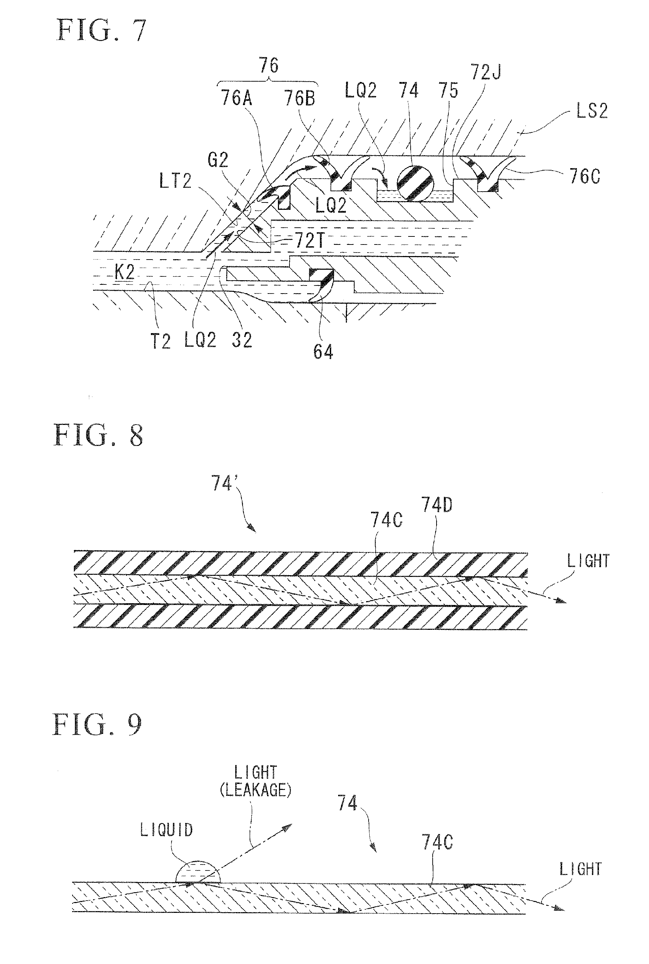

FIG. 6 is a plan top view of the second nozzle member 72. On the upper surface 72J of the nozzle member 72, a recess portion 75 for holding the second liquid LQ2 that has leaked from the second space K2 is provided outside a sealing member 76 (76B). The recess portion 75 is formed in an annular shape on the upper surface 72J of the second nozzle member 72. As shown in the schematic diagram of FIG. 7, even if the second liquid LQ2 in the second space K2 leaks to the outside of the sealing members 76 via, for example, the gap G2, the second liquid LQ2 can be held in the recess portion 75. Therefore, spread of damage due to the leaking second liquid LQ2 can be suppressed.

Furthermore, a detector 74 for detecting whether the second liquid LQ2 has leaked from the second space K2 is provided in the recess portion 75 formed in the second nozzle member 72. The detector 74 is made of an optical fiber and is disposed in the recess portion 75 formed in the second nozzle member 72, as shown in FIG. 6.

The detection principle of the detector 74 for detecting the second liquid LQ2 will be described with reference to FIG. 8 and FIG. 9. FIG. 8 is a schematic diagram showing a normal optical fiber. In FIG. 8, an optical fiber 74' includes a core portion 74C for transmitting light and a clad portion 74D which is provided around the core portion 74C and has a smaller index of refraction than the core portion 74C. In the optical fiber 74', light is transmitted while being confined in the core portion 74C having a larger index of refraction than the clad portion 74D.

FIG. 9 is a schematic diagram showing the optical fiber 74 according to this embodiment. In FIG. 9, the optical fiber 74 is an optical fiber (cladless fiber) that has the core portion 74C for transmitting light but has no clad portion therearound. The core portion 74C of the optical fiber 74 has a larger index of refraction than the gas (air in this embodiment) therearound and has a smaller index of refraction than the second liquid (pure water in this embodiment) LQ2. For this reason, if the surrounding of the optical fiber 74 is filled with air, light is transmitted while being confined in the core portion 74C having a larger index of refraction than the air. In short, light coming from the incident-end portion of the optical fiber 74 is emitted from the exit-end portion without a significant attenuation in the amount of light. On the other hand, if the second liquid (pure water) LQ2 is attached to the surface of the optical fiber 74, light leaks externally at the portion of the optical fiber 74 where the liquid is attached because total reflection does not occur in the interface area between the second liquid LQ2 and the optical fiber 74. Therefore, light coming from the incident-end portion of the optical fiber 74 attenuates the amount of light when it is emitted from the exit-end portion. For this reason, the control apparatus CONT can detect whether the second liquid LQ2 has been attached to the optical fiber 74, that is, whether the second liquid LQ2 has leaked by providing this optical fiber 74 at a predetermined position of the exposure apparatus EX and measuring the amount of light at the exit-end portion of this optical fiber 74. Because the index of refraction of air is about 1 and the index of refraction of water is about 1.4 to 1.6, the core portion 74C is preferably formed of a material having an index of refraction of, for example, about 1.2.

Furthermore, the optical fiber 74 can detect the amount of the second liquid LQ2 from the attenuation of light emitted from the exit-end portion of the optical fiber 74. More specifically, if a small amount of second liquid LQ2 is attached around the optical fiber 74, the attenuation of light at the exit-end portion is small. On the other hand, if a large amount of second liquid LQ2 is attached, then the attenuation is large. Therefore, the amount of leakage of the second liquid LQ2 can be detected by measuring the amount of light at the exit-end portion of the optical fiber 74. Furthermore, the amount of leakage of the second liquid LQ2 can be detected in a stepwise manner by comparing measurement values of the amount of light at the optical fiber exit-end portion with a plurality of preset threshold values (reference values) and issuing particular signals if respective threshold values are exceeded.

As shown in FIG. 6, the detector (optical fiber) 74 is provided in the recess portion 75 formed in the second nozzle member 72. In other words, the optical fiber 74 is disposed between the sealing member 76B and the sealing member 76C. A projector portion 77 which can emit light into the optical fiber 74 is connected to the incident-end portion of the optical fiber 74. A light receiving portion 78 which can receive light that passes through the optical fiber 74 and is emitted from the exit-end portion is connected to the exit-end portion of the optical fiber 74. Although part of the optical fiber 74 seemingly overlaps the sealing member 76C in the figure, this part of the optical fiber 74 is disposed in a cut portion formed, for example, on the upper surface of the second nozzle member 72, and hermeticity by the sealing member 76C is ensured such that the part of the optical fiber 74 does not interfere with the sealing members 76. The control apparatus CONT obtains the attenuation factor of light at the exit-end portion with respect to the incident-end portion of the optical fiber 74 based on the amount of light when it enters the optical fiber 74 from the projector portion 77 and the amount of light when it received at the light receiving portion 78, and based on the obtained result, the control apparatus CONT determines whether the second liquid LQ2 has attached to the optical fiber 74, that is, whether the second liquid LQ2 has leaked to the outside of the second space K2. When the control apparatus CONT determines that the second liquid LQ2 has leaked, it is sufficient to take an appropriate measure: for example, to stop supply operation of the second liquid LQ2 by the second liquid supply mechanism 30; to increase the recovery force of the second liquid LQ2 by the second liquid recovery mechanism 40; to stop power supply to electrical devices constituting the exposure apparatus EX; to adjust the amount of second liquid LQ2 supplied to the second space K2 or the amount of second liquid LQ2 discharged from the second space K2.

By taking an appropriate measure as described above based on the detection result of the detector 74, the control apparatus CONT can suppress the spread of damage due to the leaking second liquid LQ2; for example, the control apparatus CONT can prevent the second liquid LQ2 that has leaked from the second space K2 from flowing into the third space K3 adjacent to the upper surface T4 of the second optical element LS2. The third space K3 is a space inside the barrel PK and is maintained to be a predetermined gas environment. If the second liquid LQ2 enters this third space K3, the gas environment is disturbed, thus adversely affecting the image-forming characteristic of the projection optical system PL. Therefore, unwanted entrance of the second liquid LQ2 into the third space K3 can be prevented by providing the detector 74 capable of detecting the second liquid LQ2 so that the above-described measure can be taken when the detector 74 detects leakage of the second liquid LQ2. Furthermore, since the sealing member 76B and the sealing member 76C are provided in this embodiment, unwanted entrance of the second liquid LQ2 from the second space K2 into the third space K3 is suppressed.

As far as the sealing member 76A which is provided between the inside face 72T of the second nozzle member 72 and the side surface LT2 of the second optical element LS2 is concerned, a plurality of the sealing members 76A is preferably provided on concentric circles. Furthermore, as far as the sealing member 76B which is provided between the upper surface 72J of the second nozzle member 72 and the flange surface F2 of the second optical element LS2 facing the upper surface 72J is concerned, a plurality of the sealing members 76B is preferably provided on concentric circles. By doing so, the second liquid LQ2 held in the second space K2 can be prevented from leaking into the third space K3 or the fourth space K4 more reliably. If a plurality of the sealing members 76A is provided, the sealing member 76B may be omitted. In addition, if a plurality of the sealing members 76B is provided, the sealing member 76A may be omitted.

The detector 74 is disposed in a toric shape on the inner side of the recess portion 75 here. Alternatively, a hole portion (sampling port) may be provided, for example, at part of the recess portion 75, and the detector 74 may be provided in a space (measurement space) different from the recess portion 75 connected to the sampling port so that the detector 74 disposed in the measurement space can detect the second liquid LQ2 that has flowed into the measurement space via the sampling port.

The detector 74 can be provided not only on the upper surface 72J of the second nozzle member 72 but also at any location, as long as the detector 74 can detect leakage of the second liquid LQ2 from the second space K2 or entrance of the second liquid LQ2 into the third space K3.

A through-hole 65 for discharging the second liquid LQ2 of the second space K2 is formed at a predetermined position of the supporting member 60 holding the first optical element LS 1. In addition, a lid 66 for covering the through-hole 65 is disposed in the through-hole 65. The through-hole 65 passes though the upper surface 60J and a lower surface 60K of the supporting member 60. Here, the upper surface 60J of the supporting member 60 is provided at a position lower than the upper surface T2 of the first optical element LS1 being held. Therefore, the upper-end portion of the through-hole 65 is provided at a position lower than the upper surface T2 of the first optical element LS 1.

Next, a method of exposing a pattern image of the mask M onto the substrate P using the exposure apparatus EX with the above-described structure will be described.

When the substrate P is to be exposed, the control apparatus CONT supplies the second liquid LQ2 to the second space K2 from the second liquid supply mechanism 30 and, furthermore, recovers the second liquid LQ2 of the second space K2 by the second liquid recovery mechanism 40. Through liquid supply operation by the second liquid supply mechanism 30 and liquid recovery operation by the second liquid recovery mechanism 40, the second liquid LQ2 is filled between the upper surface T2 of the first optical element LS1 and the second optical element LS2 so that a region that includes the predetermined region AR2 through which the exposure light EL passes on the upper surface T2 of the first optical element LS1 forms the second immersion region LR2.

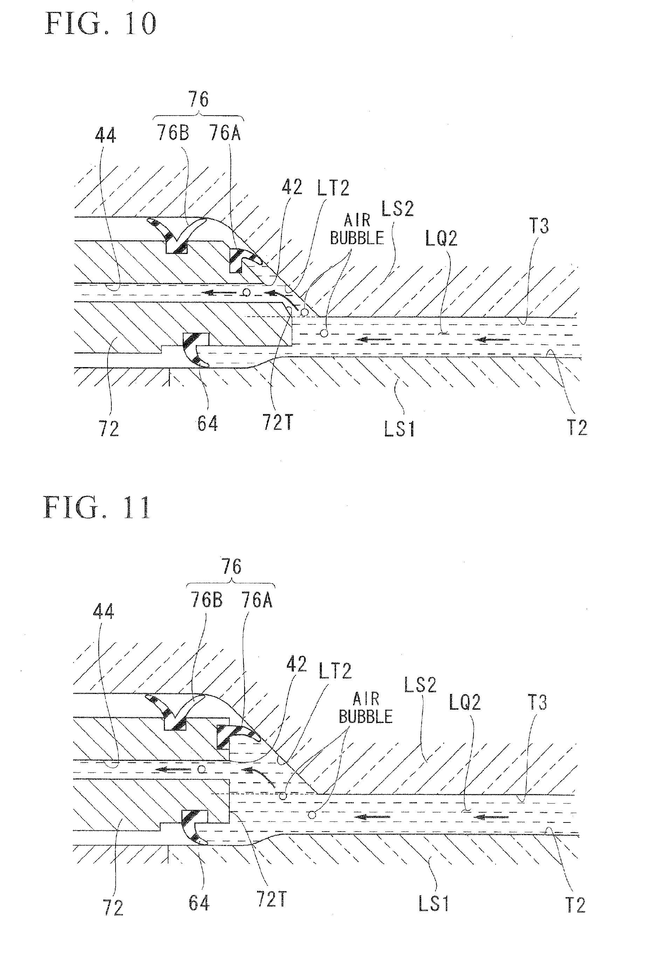

When formation of the second immersion region LR2 is started, an air portion (bubbles) may be formed in the second liquid LQ2 of the second space K2. Because bubbles work as foreign substances, the pattern transfer accuracy is degraded if bubbles (e.g., bubbles 0.1 mm or more in diameter) exist in the second liquid LQ2 of the second immersion region LR2. However, in this embodiment, supply and recovery of liquid by the second liquid supply mechanism 30 and the second liquid recovery mechanism 40 are performed concurrently when formation of the second immersion region LR2 is started, and the second collection port 42 of the second liquid recovery mechanism 40 is provided at a position higher than the lower surface T3 of the second optical element LS2. Therefore, even if bubbles exist in the second liquid LQ2, as shown in the schematic diagram of FIG. 10, the bubbles move upwards due to the difference in specific gravity from the second liquid LQ2 and are smoothly recovered from the second collection port 42 due to circulation of the second liquid LQ2 generated through the supply and recovery operation of the second liquid LQ2 by the second liquid supply mechanism 30 and the second liquid recovery mechanism 40. Therefore, the bubbles can be prevented from remaining in the second liquid LQ2 of the second immersion region LR2. Furthermore, the second liquid recovery mechanism 40 can smoothly recover not only bubbles in the second liquid LQ2 but also foreign substances having specific gravity smaller than that of the second liquid LQ2 via the second collection port 42.

After the second immersion region LR2 has been formed, the control apparatus CONT stops supplying the second liquid LQ2 by the second liquid supply mechanism 30. The second liquid LQ2 between the first optical element LS 1 and the second optical element LS2 is held in the second space K2, and the second immersion region LR2 is maintained.

After the substrate P has been loaded onto the substrate stage PST at the loading position, the control apparatus CONT moves the substrate stage PST holding the substrate P to below the projection optical system PL, that is, at the exposure position. Thereafter, in a state where the substrate stage PST is opposed to the first optical element LS1 of the projection optical system PL, the control apparatus CONT performs supply and recovery of the liquid LQ1 by the first liquid supply mechanism 10 and the first liquid recovery mechanism 20 while appropriately controlling the per-unit-of-time amount of supply of the first liquid LQ1 by the first liquid supply mechanism 10 and the per-unit-of time amount of recovery of the first liquid LQ1 by the first liquid recovery mechanism 20 and forms the first immersion region LR1 of the first liquid LQ1 at least on the optical path of the exposure light EL in the first space K1 to fill the optical path of the exposure light EL with the first liquid LQ1.

Here, a reference member (measuring member) including reference marks, which are measured by a substrate alignment system as disclosed in, for example, Japanese Unexamined Patent Application, First Publication No. H4-65603 and a mask alignment system as disclosed in Japanese Unexamined Patent Application, First Publication No. H7-176468, is provided at a predetermined position on the substrate stage PST. Furthermore, as a photometric portion, an illumination-irregularity sensor as disclosed in, for example, Japanese Published Unexamined Patent Application No. S57-117238, an aerial-image measurement sensor as disclosed in, for example, Japanese Unexamined Patent Application, First Publication No. 2002-14005, and an irradiation-amount sensor (light sensor) as disclosed in, for example, Japanese Unexamined Patent Application, First Publication No. H11-16816 are provided at predetermined positions on the substrate stage PST. Before performing exposure processing of the substrate P, the control apparatus CONT performs mark measurement on the reference member and various measurement operations using the photometric portion and, based on the measurement results, performs alignment processing of the substrate P and image-forming-characteristic adjustment (calibration) processing of the projection optical system PL. For example, when measurement using the photometric portion is to be performed, the control apparatus CONT moves the substrate stage PST relatively to the first immersion region LR1 of the first liquid LQ1 by moving the substrate stage PST in the XY direction, positions the first immersion region LR1 for the first liquid LQ1 on the photometric portion, and performs measurement via the first liquid LQ1 and the second liquid LQ2 in that state.

After the above-described alignment processing and calibration processing have been performed, the control apparatus CONT recovers the first liquid LQ 1 on the substrate P by the first liquid recovery mechanism 20 in parallel with the supply operation of the first liquid LQ1 onto the substrate P by the first liquid supply mechanism 10 and, at the same time, emits the exposure light EL onto the substrate P to expose a pattern image of the mask M onto the substrate P via the projection optical system PL, the second liquid LQ2 in the second immersion region LR2 formed adjacent to the upper surface T2 of the first optical element LS1, and the first liquid LQ1 in the first immersion region LR1 formed adjacent to the lower surface T1 of the first optical element LS1 while moving the substrate stage PST holding the substrate P in the X axial direction (predetermined scanning direction).

During exposure of the substrate P, supply operation and recovery operation of the second liquid LQ2 are not performed by the second immersion mechanism 2. In other words, exposure is performed via the second liquid LQ2 held in the second space K2. Vibration accompanied by supply and recovery of the second liquid LQ2 does not occur during exposure of the substrate P by inhibiting supply and recovery of the second liquid LQ2 during exposure of the substrate P. Therefore, deterioration in exposure accuracy due to vibration can be prevented.

In this embodiment, the first optical element LS1 made of a plane-parallel plate is disposed below the second optical element LS2 having lens power. Reflection loss on the lower surface T3 of the second optical element LS2 and on the upper surface T2 of the first optical element LS1 is decreased by filling the first liquid LQ1 and the second liquid LQ2 into the first space K1 adjacent to the lower surface T1 of the first optical element LS1 and the second space K2 adjacent to the upper surface T2, which allows the substrate P to be exposed satisfactorily while a large image-side numerical aperture is ensured.

When exposure of the substrate P is completed, the control apparatus CONT stops supply of the first liquid LQ1 by the first liquid supply mechanism 10 and recovers the first liquid LQ1 in the first immersion region LR1 (the first liquid LQ1 in the first space K1) using, for example, the first liquid recovery mechanism 20. Furthermore, the control apparatus CONT recovers the first liquid LQ1 remaining on the substrate P or on the substrate stage PST using, for example, the first collection port 22 of the first liquid recovery mechanism 20.

In addition, after exposure of the substrate P has been completed, the control apparatus CONT recovers the second liquid LQ2 from the second immersion region LR2 formed in the second space K2 via the second collection port 42 of the second liquid recovery mechanism 40 and furthermore, supplies new second liquid LQ2 to the second space K2 from the second supply outlet 32 of the second liquid supply mechanism 30. By doing so, the second liquid LQ2 held in the second space K2 is replaced. The second liquid in the second space K2 can replaced with new one by performing recovery and supply operation of this second liquid LQ2 for a predetermined period of time. When the second liquid in the second space K2 is to be replaced with a new one, the sealing member 64 may be omitted, and the second liquid LQ may be discharged via the through-hole 65 provided in the supporting member 60.

After the first liquid LQ1 on the substrate P has been recovered, the control apparatus CONT moves the substrate stage PST supporting the substrate P to the unloading position and unloads the substrate P from the substrate stage PST, and then the substrate P to be subjected to exposure processing subsequently is loaded onto the substrate stage PST. The control apparatus CONT exposes the substrate P in the same sequence as that described above.

This embodiment is constructed so as to replace the second liquid LQ2 in the second space K2 for each substrate P to be exposed. However, the second liquid LQ2 in the second space K2 may be replaced at predetermined intervals or every predetermined number of substrates that have been processed, as long as, for example, a change in temperature or degradation in the cleanness level of the second liquid LQ2 in the second space K2 does not adversely affect the exposure accuracy.

Supply and recovery of the second liquid LQ2 may be performed continuously during exposure of the substrate P and also before/after exposure of the substrate P. The second space K2 can always be filled with the clean second liquid LQ2 whose temperature is controlled by continuously performing supply and recovery of the second liquid LQ2. Also in this case, even if bubbles are mixed in the liquid, the bubbles can be smoothly recovered via the second collection port 42. On the other hand, by performing exposure in a state where the second space K2 is filled with the second liquid LQ2 and intermittently replacing the second liquid LQ2 in the second space K2 as in this embodiment, vibration accompanied by supply and recovery of the second liquid LQ2 does not occur during exposure of the substrate P, as described above. Furthermore, in a structure where supply and recovery of the second liquid LQ2 is continuously performed during exposure of the substrate P, if, for example, the per-unit-of time amount of supply and the per-unit-of time amount of recovery of the second liquid LQ2 become unstable, the second liquid LQ2 in the second space K2 may leak or scatter, thereby spreading damage. Furthermore, if the per-unit-of time amount of supply and the per-unit-of time amount of recovery of the second liquid LQ2 become unstable, the second immersion region LR2 may become dry, thereby causing an unwanted decrease in exposure accuracy. For this reason, the second immersion region LR2 is formed in a desired state by intermittently performing replacement of the second liquid LQ2 in the second space K2 to prevent the occurrence of the above-described problems. If the replacement of the second liquid LQ2 in the second space K2 is performed intermittently, the second nozzle member 72 may be in contact with the second optical element LS2 since vibration does not occur during exposure as described above.

As described above, the exposure light EL that has passed through the mask M can be made to successfully reach the substrate P, thus satisfactorily exposing the substrate P, by filling the first liquid LQ1 in the first space K1 between the lower surface T1 of the first optical element LS1 and the substrate P and also filling the second liquid LQ2 in the second space K2 between the upper surface T2 of the first optical element LS1 and the lower surface T3 of the second optical element LS2. Furthermore, since the first liquid LQ1 adjacent to the lower surface T1 of the first optical element LS1 comes into contact with the substrate P, there is high possibility that the first optical element LS1 in contact with the first liquid LQ1 is contaminated. However, since the first optical element LS1 can be easily replaced, it is sufficient to replace only the contaminated first optical element LS1 with a new one (clean one). This ensures satisfactory exposure and measurement via the projection optical system PL including the clean first optical element LS1 and the first and second liquids LQ1 and LQ2.

Since the second collection port 42 of the second immersion mechanism 2 is provided at a position higher than the lower surface T3 of the second optical element LS2, even if bubbles (air portion) exist in the second liquid LQ2 held between the upper surface T2 of the first optical element LS 1 and the lower surface T3 of the second optical element LS2, the bubbles move upward due to the difference in specific gravity between the bubbles and the second liquid LQ2. Therefore, the second collection port 42 provided at a position higher than the lower surface T3 of the second optical element LS2 can smoothly recover the bubbles. Therefore, exposure processing and measurement processing can be satisfactorily performed in a state where bubbles in the second liquid LQ2 are removed.

Furthermore, the detector 74 for detecting whether the second liquid LQ2 has leaked from the second space K2 between the first optical element LS1 and the second optical element LS2 is provided. Therefore, when the detector 74 has detected the second liquid LQ2, an appropriate measure for preventing the spread of damage due to the leaking second liquid LQ2 can be quickly taken. Therefore, undesired malfunction of devices or decrease in exposure accuracy and measurement accuracy can be prevented from occurring.

In the above-described embodiment, the inside face 72T of the second nozzle member 72 is inclined along the side surface LT2 of the second optical element LS2. However, the inside face 72T of the second nozzle member 72 may be formed so as to be substantially parallel to the vertical direction, as shown in FIG. 11, so that the distance between the lower-end portion of the inside face 72T of the second nozzle member 72 and a vicinity of the lower surface T3 of the second optical element LS2 is longer than the distances at other portions. By doing so, bubbles can be recovered more easily via the second collection port 42.

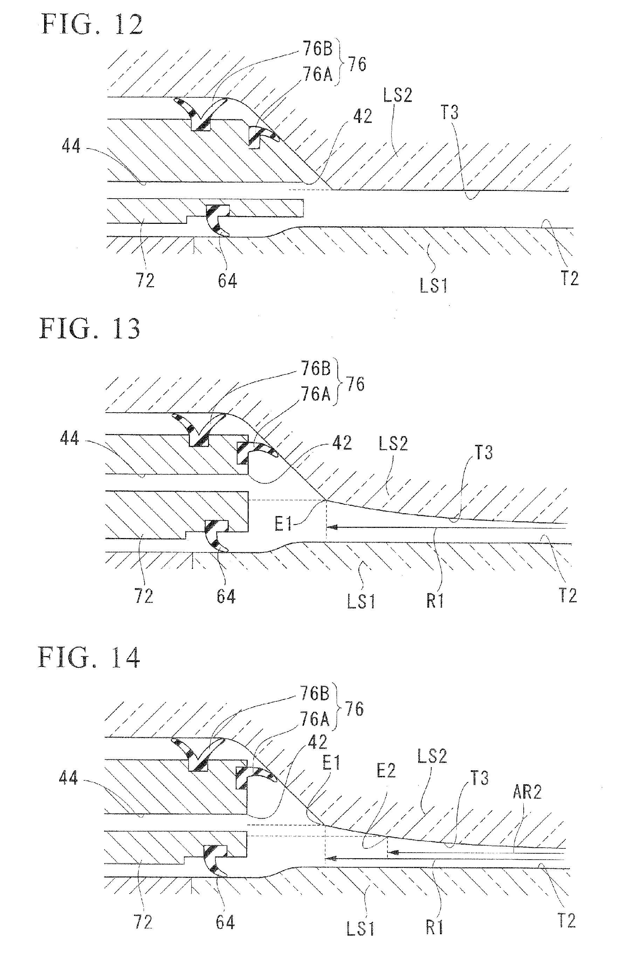

In the above-described embodiment, the entire second collection port 42 is provided at a position higher than the lower surface T3, as shown in FIG. 10 and FIG. 11. However, at least part of the second collection port 42 may be provided at a position higher than the lower surface T3, as shown in the schematic diagram of FIG. 12. On the other hand, bubbles can be recovered (removed) more smoothly by providing the entire second collection port 42 at a position higher than the lower surface T3 as in the above-described embodiment.

In the above-described embodiment, the lower surface T3 of the second optical element LS2 is shaped like a flat surface, and it is sufficient that the second collection port 42 is provided at a position higher than the flat lower surface T3. However, it is also possible that, for example, the lower surface T3 of the second optical element LS2 is in a convex shape protruding downwards, as shown in FIG. 13. In this case, it is preferable that the second collection port 42 be provided at a position higher than an edge E1 of a convex region R1 of the lower surface T3, as shown in the schematic diagram of FIG. 13. As shown in the schematic diagram of FIG. 14, the second collection port 42 may be constructed so as to be disposed at a position higher than the highest position E2 in the predetermined region AR2 through which the exposure light EL passes on the lower surface T3. By doing so, a problem such that bubbles exist in at least the region AR2 through which the exposure light EL passes can be prevented.

### <Second Embodiment>

Next, as a second embodiment, a procedure for replacing the first optical element LS 1 will be described.

If impurities generated from the substrate P, such as foreign substances resulting from photosensitive agents (photoresist), are mixed into the first liquid LQ1 in the first immersion region LR1 (the first space K1), there is danger of the first liquid LQ1 being contaminated. Since the first liquid LQ1 in the first immersion region LR1 comes into contact with the lower surface T1 of the first optical element LS1, there is possibility that the lower surface T1 of the first optical element LS1 is contaminated by the contaminated first liquid LQ1. Furthermore, there is possibility that impurities floating in the air are attached to the lower surface T1 of the first optical element LS1 exposed to the image-plane side of the projection optical system PL. For this reason, the contaminated first optical element LS1 is replaced with predetermined timing.

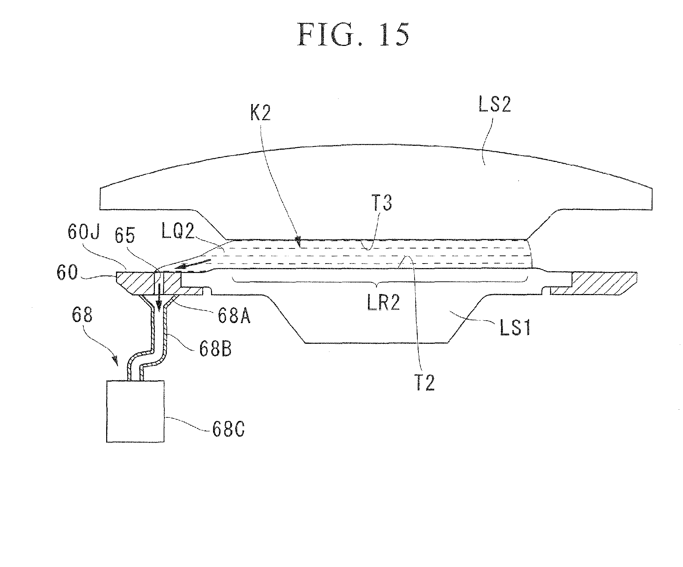

Before the first optical element LS1 is replaced, the first nozzle member 71 is removed. Then, when the first optical element LS1 is to be replaced, the connection (fixing) of the supporting member 60 to the second nozzle member 72 with the bolts 61 is released, as described above. Before releasing the connection, removal (extraction) of the second liquid LQ2 existing in the second space K2 is performed. More specifically, as shown in FIG. 15, the lid 66 disposed on the through-hole 65 is first removed. As described in the first embodiment, the sealing member 64 may be omitted, and therefore, the sealing member 64 is not shown in FIG. 15. When the lid 66 is removed, the second liquid LQ2 held in the second space K2, that is, the second liquid LQ2 in the second immersion region LR2 formed on the upper surface T2 of the first optical element LS1 is discharged externally via the through-hole 65. Here, a liquid recovery device 68 is positioned at a lower-end portion of the through-hole 65, and the second liquid LQ2 discharged via the through-hole 65 is recovered by the liquid recovery device 68. The liquid recovery device 68 includes a collection port 68A connected to a lower-end portion of the through-hole 65; a tank 68C which can accommodate the recovered second liquid LQ2; and a tube member 68B which connects the collection port 68A and the tank 68C.

Since the second collection port 42 of the second liquid recovery mechanism 40 is provided at a position higher than the lower surface T3 of the second optical element LS2, it is difficult to completely remove the second liquid LQ2 in the second space K2 using the second liquid recovery mechanism 40. For this reason, the second liquid LQ2 in the second space K2 is discharged using the through-hole 65 provided in the supporting member 60. Since an upper-end portion of the through-hole 65 is provided at a position lower than the upper surface of the first optical element LS1, the second liquid LQ2 in the second space K2 can be satisfactorily discharged externally via the through-hole 65 due to gravitation. After almost all of the second liquid LQ2 in the second space K2 has been discharged, the connection between the second nozzle member 72 and the supporting member 60 with the bolts 61 is released. By doing so, the first optical element LS1 can be removed from the barrel PK without scattering the second liquid LQ2 over devices and members (e.g., the linear motor for driving the substrate stage PST) constituting the exposure apparatus EX. Thereafter, when a new (clean) first optical element LS1 is to be mounted, the supporting member 60 holding the first optical element LS1 is mounted on the second nozzle member 72 by providing the spacer member 62 as appropriate while adjusting the positional relationship of the first optical element LS1 relative to the second optical element LS2. In the figure, only one through-hole 65 is shown. However, the through-hole 65 can be provided at any two or more positions of the supporting member 60.

In this embodiment, since the first optical element LS1 is easily attachable and detachable (replaceable) with respect to the barrel PK, degradation in the exposure accuracy due to contamination of an optical element and degradation in the measurement accuracy via the projection optical system PL can be prevented by replacing only the contaminated first optical element LS1 with a clean first optical element LS1. On the other hand, the second liquid LQ2 in the second space K2 does not come into contact with the substrate P. In addition, since the second space K2 is a substantially closed space enclosed by the first optical element LS1, the second optical element LS2, and the barrel PK, impurities floating in the air are not easily mixed into the second liquid LQ2 in the second space K2, and impurities are not easily attached to the lower surface T3 of the second optical element LS2 or the upper surface T2 of the first optical element LS1. Therefore, the cleanness levels of the lower surface T3 of the second optical element LS2 and the upper surface T2 of the first optical element LS1 are maintained. Consequently, the transmissivity of the projection optical system PL can be prevented from decreasing and the exposure accuracy and the measurement accuracy can be maintained merely by replacing the first optical element LS1.

A structure where the first optical element LS1 made of a plane-parallel plate is not provided and the liquid in the first immersion region LR1 is made to come into contact with the second optical element LS2 is also conceivable. However, in order to increase the image-side numerical aperture of the projection optical system PL, it is necessary to increase the effective diameters of the optical elements, which inevitably increases the size of the optical element LS2. Since the above-described nozzle member and, though not shown in the figure, various measuring apparatuses such as an alignment system are disposed around the optical element LS2, replacing such a large-scale optical element LS2 is difficult. Furthermore, since the optical element LS2 has refractive power (lens power), it is necessary to attach the optical element LS2 to the barrel PK with high positioning accuracy in order to maintain an optical characteristic (image-forming characteristic) of the entire projection optical system PL. Therefore, to frequently attach or detach (replace) such an optical element LS2 with respect to the barrel PK is not preferable also in terms of maintaining the optical characteristic of the projection optical system PL (positioning accuracy of the optical element LS2). Since this embodiment is constructed so as to provide a relatively compact plane-parallel plate as the first optical element LS 1 and to replace the first optical element LS1, replacement can be performed easily with high workability, and the optical characteristic of the projection optical system PL can also be maintained. By providing the first and second immersion mechanisms 1 and 2, which are capable of supplying and recovering the first and second liquids LQ1 and LQ2 independently with respect to the first space K1 adjacent to the lower surface T1 and the second space K2 adjacent to the upper surface T2 of the first optical element LS1, the exposure light EL emitted from the illumination optical system IL can be made to satisfactorily reach the substrate P disposed at adjacent to the image-plane side of the projection optical system PL while maintaining the cleanness levels of the first and second liquids LQ1 and LQ2.

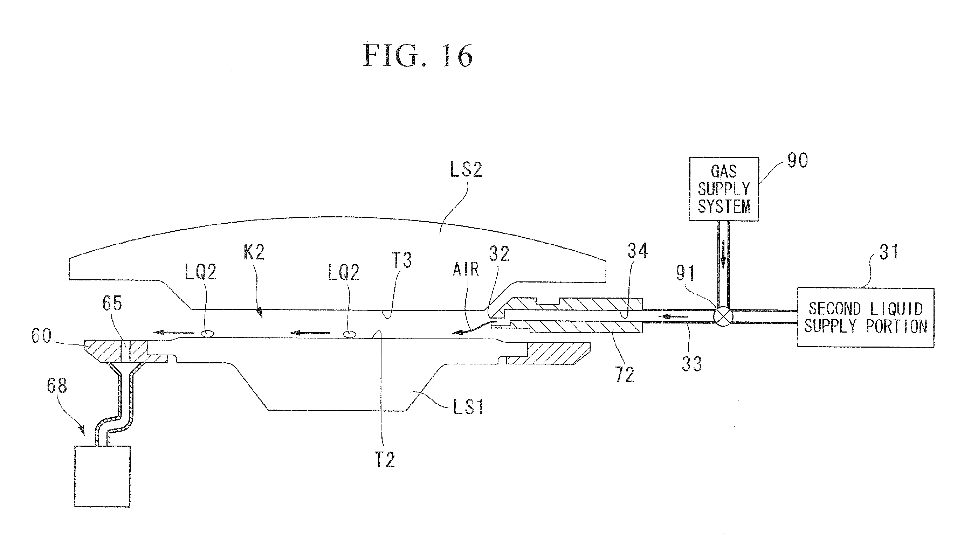

Furthermore, when the second liquid LQ2 in the second space K2 is to be discharged via the through-hole 65, a gas may be supplied (blown out) from the second supply outlet 32, as shown in FIG. 16, and the blown-out gas may be supplied to the second space K2, including the upper surface T2 of the first optical element LS1. In the example shown in FIG. 16, a gas supply system 90 is connected via a valve 91 to the supply pipe 33 which is connected to the second supply outlet 32. By switching the valve 91, when the passage connecting the second supply outlet 32 and the second liquid supply portion 31 is open, the passage connecting the second supply outlet 32 and the gas supply system 90 is closed, whereas when the passage connecting the second supply outlet 32 and the second liquid supply portion 31 is closed, the passage connecting the second supply outlet 32 and the gas supply system 90 is opened.

When liquid discharging from the second space K2 via the through-hole 65 (including replacement of the first optical element or replacement of the second liquid LQ2 with a new one) is to be performed, the control apparatus CONT drives the valve 91 to open the passage connecting the second supply outlet 32 and the gas supply system 90 and blows a gas onto the upper surface T2 of the first optical element LS1 from the second supply outlet 32. By blowing a gas in parallel with liquid discharging from the second space K2 via the through-hole 65, liquid (droplets) attached to the upper surface T2 of the first optical element LS1 smoothly moves to the through-hole 65 by the circulation of the blown gas. Therefore, the second liquid LQ2 existing in the second space K2 can be removed more satisfactorily. When a gas is to be blown, it is preferable to supply a highly humid gas at the start of liquid discharging and to supply a demoistured gas (e.g., dry air) in a predetermined period of time. Alternatively, a gas which is gradually demositured from the start of liquid discharging may be supplied. By doing so, an abrupt decrease in temperature due to heat of vaporization can be prevented.

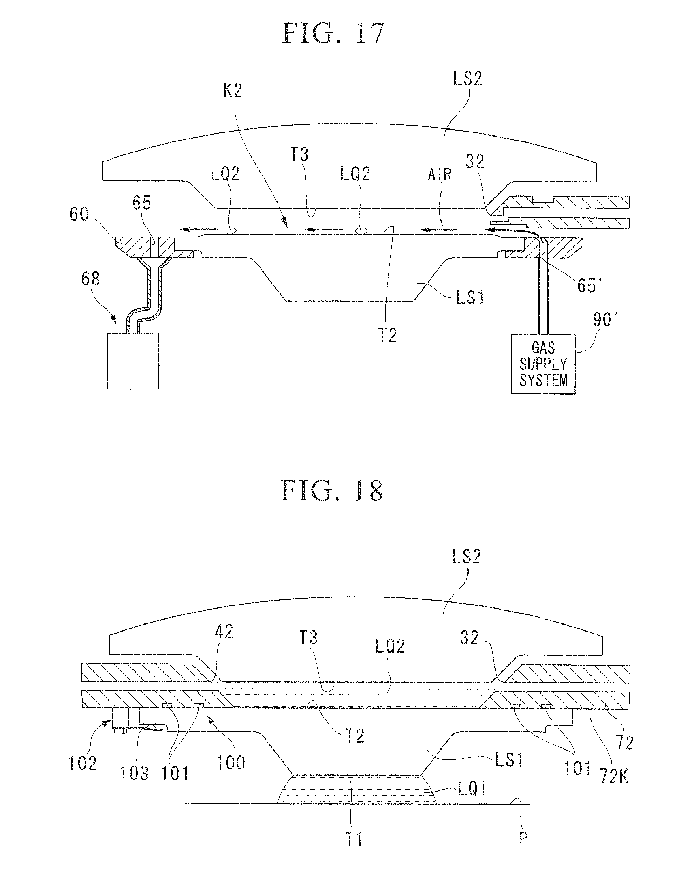

In the embodiment shown in FIG. 16, a gas is supplied from the second supply outlet 32. However, a gas can be supplied from the second collection port 42 depending on, for example, the position where the through-hole 65 is provided. Furthermore, a plurality of through-holes may be provided in the supporting member 60, a gas supply system 90' may be connected to a through-hole 65', which is different from the through-hole 65 to which the liquid recovery device 68 is connected, as shown in FIG. 17, and a gas may be supplied to the second space K2 via the through-hole 65' provided in the supporting member 60. At this time, the through-hole 65' functions as a gas port provided in the supporting member 60. The gas ejected from the through-hole 65' is blown onto, for example, the lower surface T3 of the second optical element LS2 or the upper surface T2 of the first optical element LS1. Therefore, the second liquid LQ2 attached to the upper surface T2 or the lower surface T3 can be moved to the through-hole 65.

In this embodiment, the through-hole 65 is provided in the supporting member 60 holding the first optical element LS 1 which is closest to the image plane of the projection optical system PL, and the second liquid LQ2 in the second immersion region LR2 formed on the upper surface T2 of the first optical element LS1 is discharged via the through-hole 65. However, there is possibility that an immersion region for liquid is formed on the upper surfaces of the other optical elements (LS2 to LS7). In such a case, a through-hole can be formed in a supporting member holding an optical element on whose upper surface an immersion region for liquid is to be formed.

### <Third Embodiment>

A third embodiment will be described with reference to FIG. 18. This embodiment is characterized in that the second nozzle member 72 holds the first optical element LS1 by vacuum attraction. In FIG. 18, the second nozzle member 72 includes a holding portion 100 for holding the first optical element LS1 by vacuum attraction. In the second nozzle member 72, the holding portion 100 is provided on the lower surface 72K facing the upper surface T2 of the first optical element LS1. On the upper surface T2 of the first optical element LS1, the lower surface 72K of the second nozzle member 72 opposes a region different from the region through which the exposure light EL passes. The holding portion 100 includes a vacuum attraction groove 101 formed in an annular shape on the lower surface 72K of the second nozzle member 72. A suction hole connected to the vacuum system (not shown in the figure) is formed in part of the vacuum attraction groove 101. The holding portion 100 provided in the second nozzle member 72 holds the first optical element LS 1 by vacuum attraction by driving the vacuum system while the lower surface 72K of the second nozzle member 72 is in contact with the upper surface T2 of the first optical element LS1. Furthermore, a second holding portion 102 including a leaf spring 103 is provided in the second nozzle member 72. The second holding portion 102 can hold part of the perimeter of the first optical element LS1 by the leaf spring 103. By doing so, when holding of the first optical element LS1 by vacuum attraction is not performed by the holding portion 100, the second holding portion 102 can hold the first optical element LS1 to prevent the first optical element LS1 from falling.

As described above, since the first optical element LS1 is held by vacuum attraction by the holding portion 100 provided in the second nozzle member 72, the first optical element LS1 can be easily attached/detached (replaced) with respect to the second nozzle member 72. Therefore, replacing the first optical element LS1 with a new one (clean one) can be smoothly performed with high workability. In addition, since the holding portion 100 is provided in the second nozzle member 72, the supporting member 60 described in the foregoing first and second embodiments can be omitted. Furthermore, the number of components in the apparatus can be reduced, the apparatus can be made simple (small), and the cost of the apparatus can be reduced compared with a structure where a vacuum-attraction portion is provided separately from the second nozzle member 72.

In the above-described first to third embodiments, the barrel PK is a member different from the second nozzle member 72, and the barrel PK is integrated with the second nozzle member 72 when the second nozzle member 72 is connected to a lower-end portion of the barrel PK. Alternatively, the second supply outlet 32, the second collection port 42, the second supply passage 34, and the second recovery passage 44 may be formed in the barrel PK. In short, the barrel PK may be allowed to have the function of the second nozzle member 72. In this case, the barrel PK (the second nozzle member 72) holds the optical elements LS2 to LS7 and furthermore, holds the first optical element LS1 by vacuum attraction by providing the holding portion 100, described in the third embodiment, on a lower-end face of the barrel PK. Thus, the first optical element LS1 can be easily attached and detached.

Although the first nozzle member 71 is separated from the barrel PK in the above-described first to third embodiments, the first nozzle member 71 may be fixed to the barrel PK, as long as deterioration in exposure accuracy due to vibration is minor.

In the above-described first to third embodiments, from among the plurality of optical elements LS1 to LS7, at least the first and second optical elements LS1 and LS2, which are in contact with the first and second liquids LQ1 and LQ2, are formed of quartz. Since quartz has high affinity with the first and second liquids LQ1 and LQ2 as water, the first and second liquids LQ1 and LQ2 can be brought into close contact with almost all area of the lower surface T1 and the upper surface T2, which are liquid-contact surfaces of the first optical element LS1, and the lower surface T3, which is a liquid-contact surface of the second optical element LS2. Therefore, the optical path between the second optical element LS2 and the first optical element LS1 can be filled with the second liquid LQ2, and furthermore, the optical path between the first optical element LS1 and the substrate P can be filled with the first liquid LQ1 while the first and second liquids LQ1 and LQ2 are made to be in close contact with the liquid-contact surfaces of the first and second optical elements LS1 and LS2 to prevent bubbles from occurring.

Furthermore, since quartz is a material having a large index of refraction, the size of, for example, the second optical element LS2 can be reduced, and therefore, the overall sizes of the projection optical system PL and the exposure apparatus EX can be reduced. In addition, since quartz is resistant to water, it is advantageous, for example, in that it is not necessary to provide a protection film on the above-described liquid-contact surfaces.

At least one of the first and second optical elements LS1 and LS2 may be made of fluorite which has high affinity with water. Furthermore, for example, the optical elements LS3 to LS7 may be formed of fluorite, while the optical elements LS1 and LS2 may be formed of quartz. Alternatively, all of the optical elements LS1 to LS7 may be formed of quartz (or fluorite).

In addition, hydrophilicity (lyophilicity) treatment may be applied to the liquid-contact surfaces of the first and second optical elements LS1 and LS2 (e.g., applying lyophilic materials such as MgF₂, Al2O₃, or SiO₂) to increase affinity with the first and second liquids LQ1 and LQ2. Alternatively, since the first and second liquids LQ1 and LQ2 in this embodiment are water with large polarity, the liquid-contact surfaces of these optical elements LS1 and LS2 can be made hydrophilic by forming a thin film of material of molecular structure with large polarity, such as alcohol, for lyophilicity treatment (hydrophilicity treatment).

On the other hand, problems, for example, in that the first liquid LQ1 leaks to the outside of the substrate stage PST or the first liquid LQ1 remains on the substrate stage PST after recovery operation of the first liquid LQ1 has been performed subsequently to, for example, the completion of immersion exposure can be prevented from occurring by making, for example, the upper surface 56 of the substrate stage PST liquid-repellent. Such liquid-repellency treatment for endowing liquid-repellent property includes treatment such as applying liquid-repellent materials, for example, fluorocarbon resin material (including fluorocarbon rubber) such as polytetrofluroethelene (Teflon (registered trademark)), acrylic resin material, silicon resin material, and PFA (tetrafluoroethylene-perfluoroalkoxy ethylene copolymer). By endowing the upper surface 56 of the substrate stage PST with liquid-repellent property, leakage of the first liquid LQ1 to the outside of the substrate P (outside of the upper surface 56) can be prevented during immersion exposure, and furthermore, the first liquid LQ1 can be smoothly recovered even after immersion exposure, thus preventing a problem such that the first liquid LQ1 remains on the upper surface 56.

### <Fourth Embodiment>

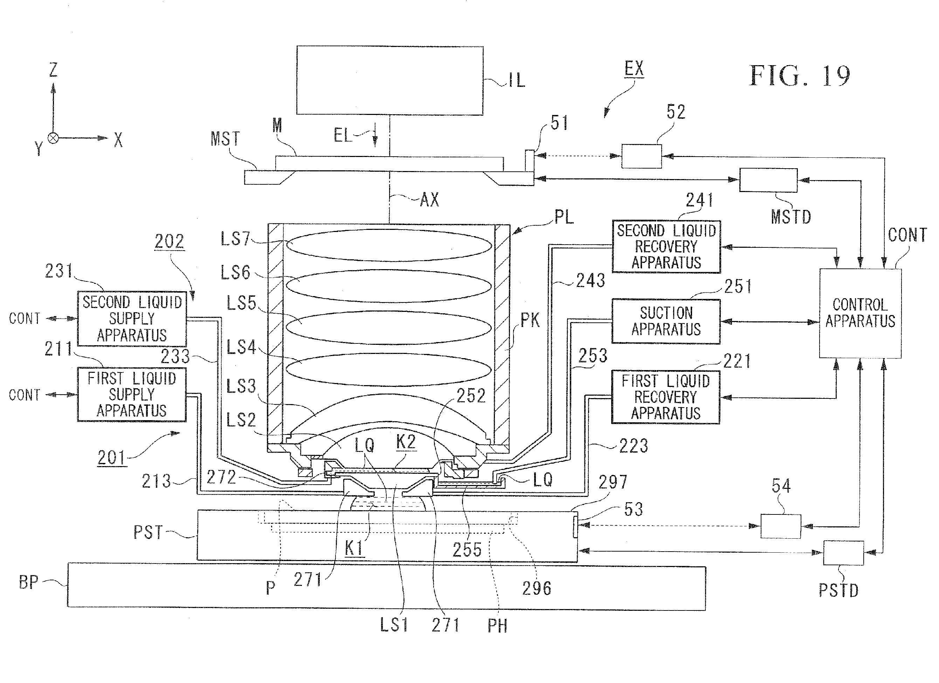

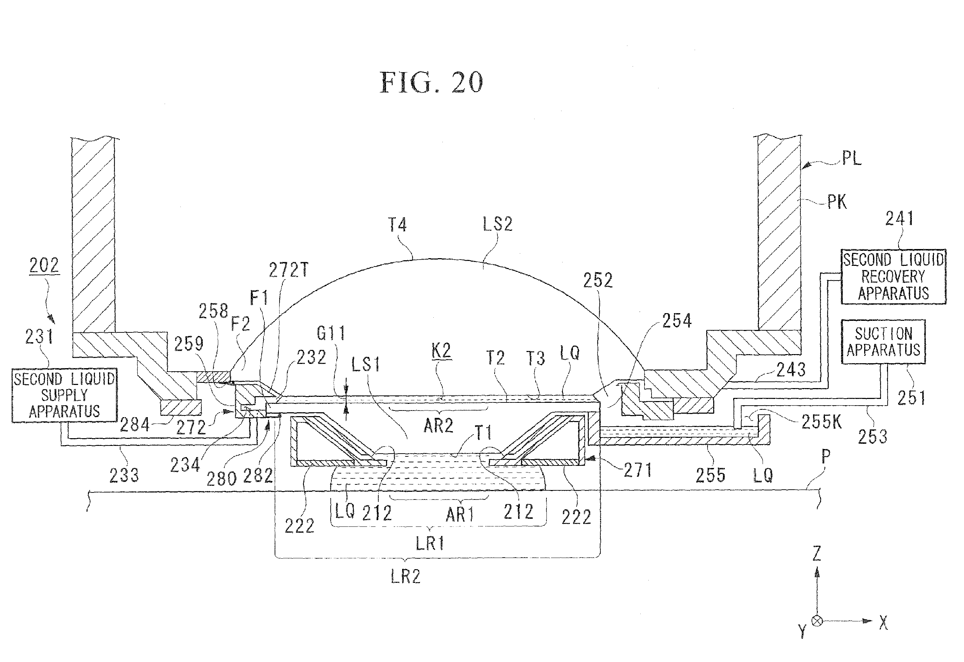

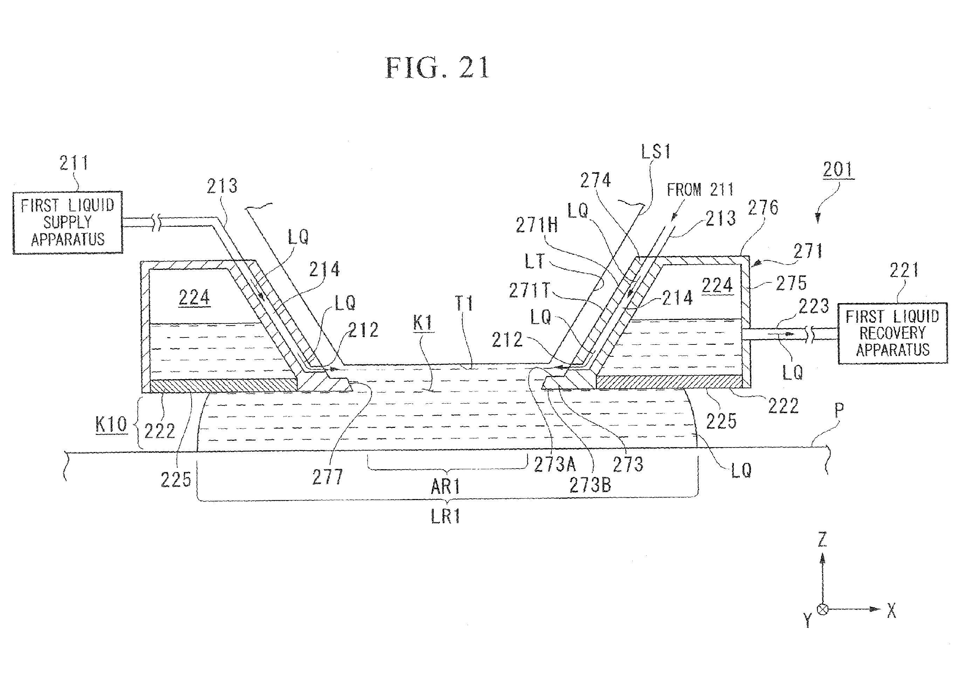

A fourth embodiment will be described. FIG. 19 is a schematic block diagram showing the exposure apparatus EX according to the fourth embodiment, and FIG 20 and FIG. 21 are enlarged views of the main part of FIG. 19. In the following description, components same as or equivalent to those in the first embodiment are described only briefly, or a description thereof is omitted.

The exposure apparatus EX of this embodiment includes a first immersion mechanism 201 for filling a liquid LQ in the first space K1, which is an optical path space of the exposure light EL between the first optical element LS1 and the substrate P. The first immersion mechanism 201 is disposed adjacent to the first space K1 and includes a first nozzle member 271 having a supply outlet 212 for supplying the liquid LQ and a collection port 222 for recovering the liquid LQ; a first liquid supply apparatus 211 for supplying the liquid LQ via a supply pipe 213 and the supply outlet 212 provided in the first nozzle member 271; and a first liquid recovery apparatus 221 for recovering the liquid LQ via the collection port 222 provided in the first nozzle member 271 and a recovery pipe 223. The operation of the first immersion mechanism 201 including the first liquid supply apparatus 211 and the first liquid recovery apparatus 221 is controlled by the control apparatus CONT.

Furthermore, the exposure apparatus EX includes a second immersion mechanism 202 for filling the liquid LQ in the second space K2, which is an optical path space of the exposure light EL between the first optical element LS1 and the second optical element LS2. The second immersion mechanism 202 is disposed adjacent to the second space K2 and includes a second nozzle member 272 having a supply outlet 232 for supplying the liquid LQ and a collection port (242) for recovering the liquid LQ; a second liquid supply apparatus 231 for supplying the liquid LQ via a supply pipe 233 and the supply outlet 232 provided in the second nozzle member 272; and a second liquid recovery apparatus 241 for recovering the liquid LQ via the collection port (242) provided in the second nozzle member 272 and a recovery pipe 243. The collection port (242) is not shown in FIG. 19 to FIG. 21.

Furthermore, the second immersion mechanism 202 is formed between the first optical element LS1 and the second nozzle member 272 and includes a discharge outlet 252 for discharging the liquid LQ in the second space K2; a collection member 255 for collecting the liquid LQ discharged from the discharge outlet 252; and a suction apparatus 251 for suck-recovering, via a suction pipe 253, the liquid LQ collected by the collection member 255. The operation of the second immersion mechanism 202 including the second liquid supply apparatus 231, the second liquid recovery apparatus 241, and the suction apparatus 251 is controlled by the control apparatus CONT control.

Also in this embodiment, pure water is used as the liquid LQ.

Next, the first immersion mechanism 201 will be described with reference to FIG 21. FIG. 21 is a sectional side view of a vicinity of the first nozzle member 271. The first liquid supply apparatus 211 of the first immersion mechanism 201 supplies the liquid LQ to fill the liquid LQ in the first space K1, which is an optical path space between the first optical element LS1 and the substrate P, and includes a tank which stores the liquid LQ; a pressurizing pump; a temperature-regulating apparatus for adjusting the temperature of the liquid LQ to be supplied; a filter unit for removing foreign substances in the liquid LQ; and so forth. One end portion of the supply pipe 213 is connected to the first liquid supply apparatus 211, and the other end portion of the supply pipe 213 is connected to the first nozzle member 271. The liquid supply operation of the first liquid supply apparatus 211 is controlled by the control apparatus CONT. The exposure apparatus EX does not need to include all of the tank, the pressurizing pump, the temperature-regulating apparatus, the filter unit, and so forth in the first liquid supply apparatus 211, and facilities in the factory where the exposure apparatus EX is installed may be used instead.

The first liquid recovery apparatus 221 of the first immersion mechanism 201 recovers the liquid LQ held in the first space K1, which is the optical path space between the first optical element LS1 and the substrate P, and includes a vacuum system such as a vacuum pump; a gas-liquid separator for separating a gas from the recovered liquid LQ; a tank which stores the recovered liquid LQ; and so forth. One end portion of the recovery pipe 223 is connected to the first liquid recovery apparatus 221, and the other end portion of the recovery pipe 223 is connected to the first nozzle member 271. The liquid recovery operation of the first liquid recovery apparatus 221 is controlled by the control apparatus CONT. The exposure apparatus EX does not need to include all of the vacuum system, the gas-liquid separator, the tank, and so forth in the first liquid recovery apparatus 221, and facilities in the factory where the exposure apparatus EX is installed may be used instead.

The first nozzle member 271 is an annular shape member provided so as to enclose the first optical element LS1 and has, at the central portion thereof, a hole portion 271H which can accommodate part of the first optical element LS1. The first nozzle member 271 has a bottom plate portion 273 facing the surface of the substrate P held on the substrate stage PST; an inclined plate portion 274 facing a side surface LT of the first optical element LS 1 ; a side plate portion 275; and a top plate portion 276. The inclined plate portion 274 is formed in a bowl shape, and the first optical element LS 1 is disposed on the inner side of the hole portion 271H formed by the inclined plate portion 274. The side surface LT of the first optical element LS1 opposes an inside face 271T of the hole portion 271H in the first nozzle member 271 with a predetermined gap therebetween. The bottom plate portion 273 is disposed between the lower surface T1 of the first optical element LS1 and the substrate P. An opening 277 through which the exposure light EL passes is formed in the bottom plate portion 273. An upper surface 273A of the bottom plate portion 273 opposes the lower surface T1 of the first optical element LS1 with a predetermined gap therebetween, and a lower surface 273B of the bottom plate portion 273 opposes the surface of the substrate P with a predetermined gap therebetween. The upper surface 273A of the bottom plate portion 273 is connected to a lower-end portion of the inside face 271T. The lower surface 273B of the bottom plate portion 273 is a flat surface.

The first nozzle member 271 includes the supply outlet 212 for supplying the liquid LQ to the first space K1, which is an optical path space of the exposure light EL, and the collection port 222 for recovering the liquid LQ of the first space K1. Furthermore, the first nozzle member 271 includes a supply passage 214 connected to the supply outlet 212 and a recovery passage 224 connected to the collection port 222.

The supply outlet 212 supplies the liquid LQ to the first space K1 and is provided adjacent to the upper surface 273A of the bottom plate portion 273 on the inside face 271T of the first nozzle member 271. The supply outlet 212 is provided outside the first space K1, and in this embodiment, the supply outlet 212 is provided on each side of the first space K1 in the X axial direction. The supply outlet 212 may be provided on each side of the first space K1 in the Y axial direction, or a plurality of the supply outlets 212 may be provided so as to enclose the first space K1.

The supply passage 214 is formed of a slit-shaped through-hole which passes through the inclined plate portion 274 of the first nozzle member 271 along an oblique direction. The supply outlet 212 and the supply pipe 213 are connected via the supply passage 214. The other end portion of the supply pipe 213 is connected to the upper-end portion of the supply passage 214, and the supply outlet 212 is connected to the lower-end portion of the supply passage 214. Therefore, the first liquid supply apparatus 211 and the supply outlet 212 are connected via the supply pipe 213 and the supply passage 214, and the liquid LQ is supplied to the supply outlet 212 from the first liquid supply apparatus 211.

The liquid LQ supplied from the supply outlet 212 is filled in a predetermined space K10 between the projection optical system PL and the lower surface of the first nozzle member 271 and the surface of the substrate P, including the first space K1. The liquid LQ is held between the projection optical system PL and the first nozzle member 271 and the substrate P.

The collection port 222 recovers the liquid LQ in the optical path space K1 and is provided on the lower surface opposing the substrate P in the first nozzle member 271. The collection port 222 is provided in an annular shape so as to enclose the first space K1 at the outside of the supply outlet 212 and the bottom plate portion 273 with respect to the first space K1.

The recovery passage 224 is provided inside the first nozzle member 271. In the first nozzle member 271, a space which opens downwards is formed between the inclined plate portion 274 and the side plate portion 275, and the recovery passage 224 is formed of the space. The collection port 222 is disposed in the opening of the space and is connected to the recovery passage 224. The other end portion of the recovery pipe 223 is connected to part of the recovery passage 224. Therefore, the first liquid recovery apparatus 221 and the collection port 222 are connected via the recovery passage 224 and the recovery pipe 223. By placing the recovery passage 224 into negative pressure, the first liquid recovery apparatus 221, including the vacuum system, can recover, via the collection port 222, the liquid LQ existing in the predetermined space K10 between the first nozzle member 271 and the projection optical system PL and the substrate P, including the first space K1. The liquid LQ held in the first space K1 (the predetermined space K10) flows into the recovery passage 224 via the collection port 222 of the first nozzle member 271, and the liquid LQ that has flowed into the recovery passage 224 is recovered by the first liquid recovery apparatus 221.

The first nozzle member 271 includes a porous member 225 having a plurality of holes provided so as to enclose the collection port 222. The porous member 225 is formed in an annular shape in plan view. The porous member 225 can be made of, for example, a mesh member having a plurality of holes. Materials of which the porous member 225 can be formed include quartz, titanium, stainless steel (e.g., SUS316), and ceramics or hydrophilic materials. The first liquid recovery apparatus 221 of the first immersion mechanism 201 recovers the liquid LQ in the first space K1 (the predetermined space K10) via the porous member 225.

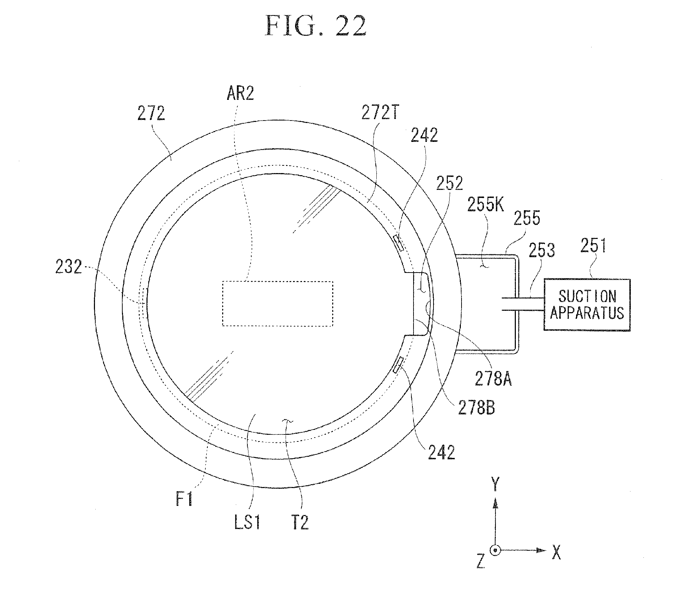

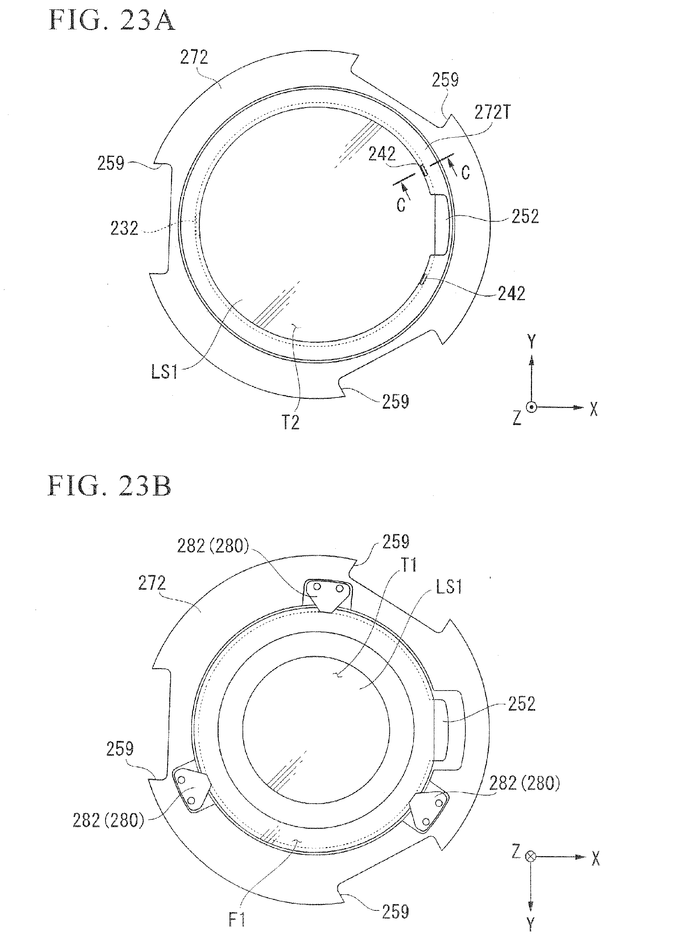

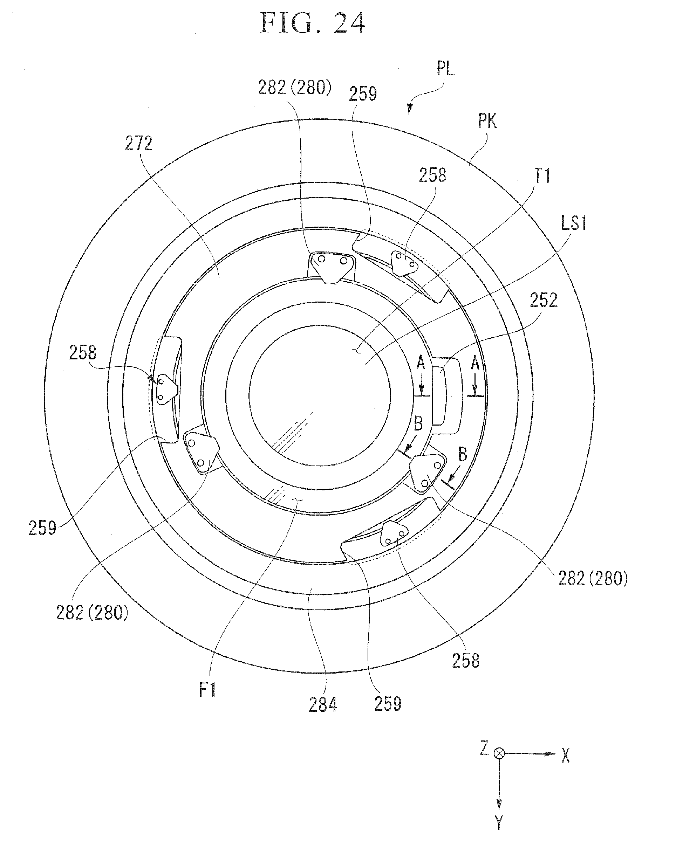

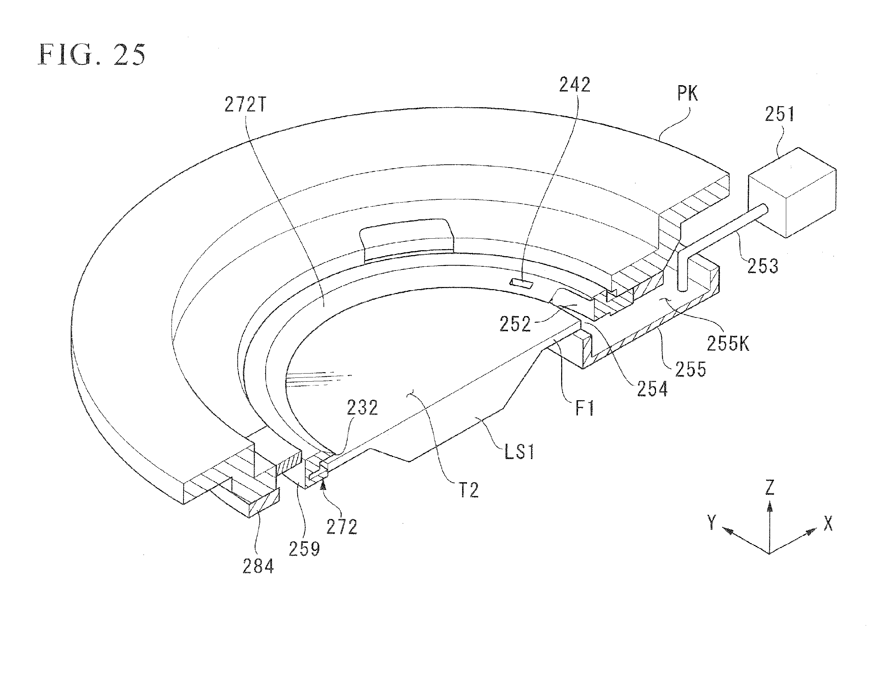

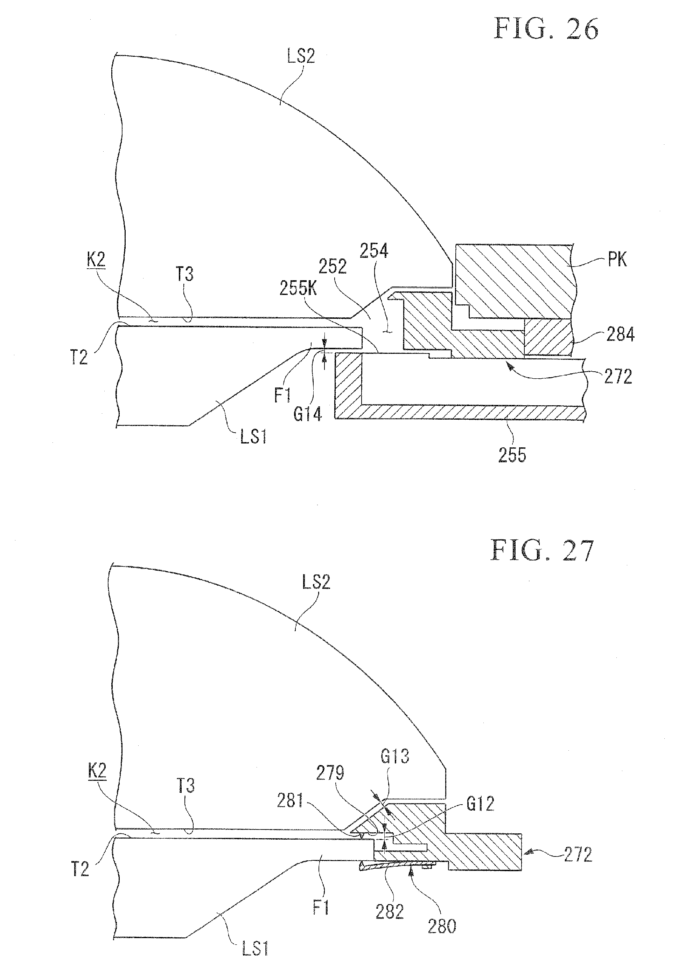

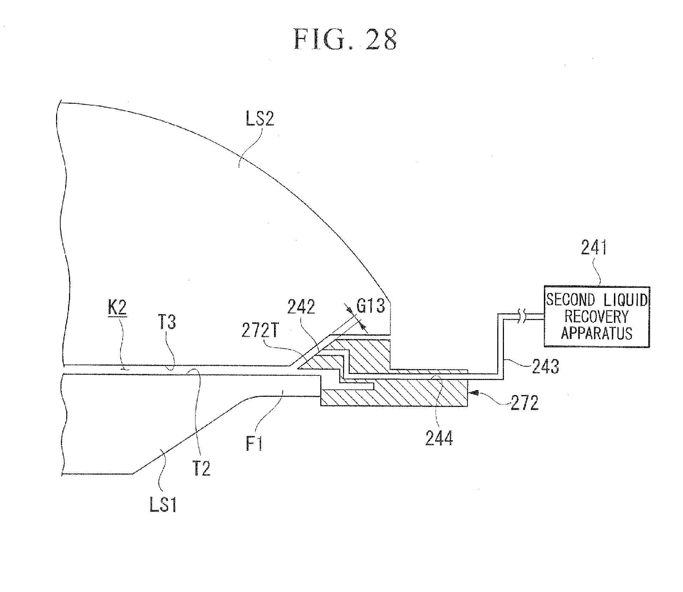

Next, the second immersion mechanism 202 will be described with reference to FIG. 20 and FIG. 22 to FIG. 28. FIG. 22 is a schematic top view of a vicinity of the first optical element LS1 and the second nozzle member 272. FIGS. 23A and 23B are diagrams showing the first optical element LS1 supported by the second nozzle member 272. FIG. 23A is a top view, and FIG. 23B is a bottom view. FIG. 24 is a bottom view of the projection optical system PL. FIG. 25 is a cross-sectional perspective view of a vicinity of the second nozzle member 272. FIG. 26 to FIG. 28 are enlarged cross-sectional views of the main part of the second nozzle member 272. FIG. 26 corresponds to a cross-sectional view taken along line A-A of FIG. 24. FIG. 27 corresponds to a cross-sectional view taken along line B-B of FIG 24. FIG. 28 corresponds to a cross-sectional view taken along line C-C of FIG 23A.

As shown in FIG. 20, the first optical element LS 1 is a plane-parallel plate that can transmit the exposure light EL and has no refractive power, and the upper surface T2 and the lower surface T1 are parallel. The first optical element LS1 has the flange portion F1. The second nozzle member 272 is provided so as to enclose the flange portion F1 of the first optical element LS1. A support portion 280 for supporting the outer circumferential portion (the flange portion F1) of the first optical element LS1 is provided in the second nozzle member 272. The lower surface T1 and the upper surface T2 of the first optical element LS1 supported by the support portion 280 are substantially parallel to the XY plane. Since the surface of the substrate P supported on the substrate stage PST is substantially parallel to the XY plane, the lower surface T1 and the upper surface T2 are substantially parallel to the surface of the substrate P supported on the substrate stage PST.

The second optical element LS2 is an optical element having refractive power (lens power) and has the flat lower surface T3 and the upper surface T4 which is formed in a convex shape protruding towards the object-surface side (the mask M) to exhibit positive refractive power. Since the upper surface T4 of the second optical element LS2 has positive refractive power, reflection loss in the light (the exposure light EL) incident upon the upper surface T4 is reduced, which eventually ensures a large image-side numerical aperture.

The second optical element LS2 has a flange portion F2. The flange portion F2 of the second optical element LS2 is supported by the support mechanism 258 provided at a lower-end portion of the barrel PK. The second optical element LS2 having refractive power (lens power) is supported by the support mechanism 258 of the barrel PK in a satisfactorily positioned state. The lower surface T3 of the second optical element LS2 supported by the support mechanism 258 and the upper surface T2 of the first optical element LS1 supported by the support portion 280 of the second nozzle member 272 are substantially parallel.

The second liquid supply apparatus 231 of the second immersion mechanism 202 supplies the liquid LQ to fill the liquid LQ in the second space K2, which is an optical path space between the upper surface T2 of the first optical element LS1 and the lower surface T3 of the second optical element LS2, and has a similar structure as that of the first liquid supply apparatus 211 of the first immersion mechanism 201. In short, the second liquid supply apparatus 231 includes a tank for accommodating the liquid LQ, a pressurizing pump, a temperature regulator for adjusting the temperature of the liquid LQ to be supplied, a filter unit for removing foreign substances in the liquid LQ, and so forth. One end portion of the supply pipe 233 is connected to the second liquid supply apparatus 231, and the other end portion of the supply pipe 233 is connected to the second nozzle member 272. The liquid supply operation of the second liquid supply apparatus 231 is controlled by the control apparatus CONT.

The second nozzle member 272 is connected to a lower-end portion (lower surface) of the barrel PK and is supported on the barrel PK. In this embodiment, the first optical element LS1 and the second nozzle member 272 supporting the first optical element LS1 are provided so as to be attachable/detachable with respect to the barrel PK. The supply outlet 232 for supplying the liquid LQ to the second space K2 is provided in a predetermined position of the second nozzle member 272 supporting the first optical element LS 1. The supply outlet 232 supplies the liquid LQ to the upper surface T2 of the first optical element LS1 so that the predetermined region AR2 through which the exposure light EL passes on the upper surface T2 of the first optical element LS1 forms the second immersion region LR2 and is provided outside the predetermined region AR2.

The supply outlet 232 is provided at a position opposing the second space K2 on an inside face 272T of the second nozzle member 272. In this embodiment, the supply outlet 232 is provided at a predetermined position on the -X side from the predetermined region AR2 in the second nozzle member 272. Furthermore, a supply passage 234, which is an internal passage connecting the supply outlet 232 and the supply pipe 233, is provided inside the second nozzle member 272.

As shown in FIG. 20 and FIG. 22 to FIG. 26, the discharge outlet 252 for discharging the liquid LQ from the second space K2 is formed between the flange portion F1 of the first optical element LS1 and the second nozzle member 272. The upper-end portion of the discharge outlet 252 is provided at a position substantially the same height as or lower than the predetermined region AR2 on the upper surface T2 of the first optical element LS 1.

As shown in FIG. 22, a cut portion 278A is formed in a predetermined position of the inner marginal portion of the second nozzle member 272, and a cut portion 278B is also formed in a predetermined position of the outer marginal portion (the flange portion F1) of the first optical element LS 1. The discharge outlet 252 is provided between the cut portion 278A of the second nozzle member 272 and the cut portion 278B of the first optical element LS1. Furthermore, the discharge outlet 252 is provided outside the predetermined region AR2.

The discharge outlet 252 is provided at the opposite side of the predetermined region AR2, through which the exposure light EL passes, on the upper surface T2 of the first optical element LS1 from the supply outlet 232, that is, at a position symmetrical to the supply outlet 232 about the predetermined region AR2. In this embodiment, the discharge outlet 252 is provided on the +X side of the predetermined region AR2. Furthermore, the cut portion 278A of the second nozzle member 272 is formed in a "U" shape in plan view, and the cut portion 278B of the first optical element LS1 is formed in a line in plan view. The discharge outlet 252 formed between the first optical element LS1 and the second nozzle member 272 is substantially rectangular in plan view.

Furthermore, as shown in, for example, FIG. 20, FIG 25, and FIG. 26, the discharge outlet 252 is connected to the flange portion F1 of the first optical element LS1 and to the space below the second nozzle member 272 via a discharge passage 254. In other words, the discharge passage 254 is a through-hole connecting the spaces below and above the flange portion F1 of the first optical element LS1 and the second nozzle member 272. The discharge passage 254 is formed between the cut portion 278A of the second nozzle member 272 and the cut portion 278B of the first optical element LS1.

The collection member 255 for collecting the liquid LQ discharged from the discharge outlet 252 is provided below the flange portion F1 of the first optical element LS1 and the second nozzle member 272. The collection member 255 is connected to at least one of the lower surface of the flange portion F 1 of the first optical element LS1 and the lower surface of the second nozzle member 272. In this embodiment, the collection member 255 is connected to the lower surface of the second nozzle member 272. Furthermore, the collection member 255 is attachable and detachable with respect to the second nozzle member 272. The second nozzle member 272 and the collection member 255 may be formed integrally.

The collection member 255 has an opening 255K at the upper part thereof and is a container that can accommodate the liquid LQ. The discharge passage 254 is connected to the opening 255K of the collection member 255 via a space. Therefore, the liquid LQ discharged via the discharge outlet 252 from the second space K2 flows through the discharge passage 254 and is then collected in the collection member 255.

As shown in, for example, FIG. 20, FIG. 22, and FIG. 25, the suction apparatus 251 is connected to the collection member 255 via the suction pipe 253. The suction apparatus 251 suck-recovers the liquid LQ that has been discharged from the discharge outlet 252 and collected in the collection member 255 and includes a vacuum system such as a vacuum pump, a gas-liquid separator for separating a gas from the recovered liquid LQ, a tank for accommodating the recovered liquid LQ, and so forth. One end portion of the suction pipe 253 is connected to the suction apparatus 251, and the other end portion of the suction pipe 253 is connected to the collection member 255. The suction and recovery operation of the suction apparatus 251 is controlled by the control apparatus CONT. The control apparatus CONT suck-recovers the liquid LQ collected in the collection member 255 by driving the suction apparatus 251.

In FIG. 20 and FIG. 28, the second liquid recovery apparatus 241 of the second immersion mechanism 202 recovers the liquid LQ in the second space K2, which is an optical path space between the upper surface T2 of the first optical element LS 1 and the lower surface T3 of the second optical element LS2, and has a similar structure as that of the first liquid recovery apparatus 221 of the first immersion mechanism 201. More specifically, the second liquid recovery apparatus 241 includes a vacuum system such as a vacuum pump; a gas-liquid separator for separating a gas from the recovered liquid LQ; a tank which stores the recovered liquid LQ; and so forth. One end portion of the recovery pipe 243 is connected to the second liquid recovery apparatus 241, and the other end portion of the recovery pipe 243 is connected to the second nozzle member 272. The liquid recovery operation of the second liquid recovery apparatus 241 is controlled by the control apparatus CONT.

As shown in, for example, FIG. 22, FIG. 23A, FIG. 25, and FIG. 28, the collection port 242 for recovering the liquid LQ is connected to a predetermined position of the second nozzle member 272. The collection port 242 is for recovering the liquid LQ of the second space K2 and is provided on the inside face 72T of the second nozzle member 272 and at a position higher than the predetermined region AR2 on the upper surface T2 of the first optical element LS1.

On the inside face 272T of the second nozzle member 272, the collection port 242 is provided at the opposite side of the predetermined region AR2 from the supply outlet 232 and adjacent to the discharge outlet 252. In this embodiment, the collection port 242 is provided at a predetermined position on each side of the discharge outlet 252 on the inside face 272T of the second nozzle member 272.

The collection port 242 is connected to the second liquid recovery apparatus 241 via a recovery passage 244 formed inside the second nozzle member 272 and the recovery pipe 243. By driving the second liquid recovery apparatus 241 including the vacuum system, the control apparatus CONT can recover the liquid LQ between the first optical element LS1 and the second optical element LS2, including the second space K2, via the collection port 242. In the same manner as with the collection port 222 of the first immersion mechanism 201, a porous member may be provided on the collection port 242 of the second immersion mechanism 202.

As shown in, for example, FIGS. 23A and 23B, FIG. 24, and FIG. 27, the support portion 280 for supporting the first optical element LS1 is provided in the second nozzle member 272. The support portion 280 provided in the second nozzle member 272 supports the flange portion F1 provided at the outer circumferential portion of the first optical element LS1 and includes a protrusion 281 which is provided on a predetermined surface 279, in the second nozzle member 272, facing the peripheral region of the upper surface T2 of the first optical element LS 1 and which is in contact with the upper surface T2 of the first optical element LS1; and a plank-shaped member 282 which is mounted on the lower surface of the second nozzle member 272 and supports the lower surface of the flange portion F1 of the first optical element LS1. The predetermined surface 279 is provided in a substantially toric shape along the perimeter of the upper surface T2 of the first optical element LS1 at the portion other than the cut portion 278A. The protrusion 281 is provided along the circumferential direction of the predetermined surface 279 at each of a plurality of predetermined positions and protrudes downwards from the predetermined surface 279 towards the upper surface T2 of the first optical element LS1. In this embodiment, the protrusions 281 are provided along the circumferential direction of the predetermined surface 279 at three locations separated at predetermined intervals. In addition, a predetermined gap G12 is formed between the predetermined surface 279 of the second nozzle member 272 and the upper surface T2 of the first optical element LS by the protrusions 281.

The plank-shaped member 282 includes an elastic member such as a leaf spring. One end portion thereof (the end portion distant from the optical axis AX) is fixed to the lower surface of the second nozzle member 272 with, for example, a bolt member, and the other end portion thereof (the end portion adjacent to the optical axis AX) is in contact with the lower surface of the flange portion F1 of the first optical element LS1. As shown in, for example, FIGS. 23A and 23B and FIG. 24, the plank-shaped member 282 is provided at each of a plurality of predetermined positions along the circumferential direction of the second nozzle member 272, and in this embodiment, the plank-shaped members 282 are provided along the circumferential direction of the second nozzle member 272 at three locations separated at predetermined intervals.

In this manner, the second nozzle member 272 includes a function as a supporting mechanism for supporting the first optical element LS1 and a function as an immersion mechanism for forming the second immersion region LR2.

As described above, the second nozzle member 272 supporting the first optical element LS 1 is provided so as to be attachable/detachable with respect to the barrel PK. However, the exposure apparatus EX of this embodiment, as shown in FIG. 24, includes an alignment ring 284 as a positioning member which is used when the second nozzle member 272 supporting the first optical element LS1 is to be attached to the barrel PK. When the second nozzle member 272 is to be attached to the barrel PK, the alignment ring 284 is first attached to the lower-end portion of the barrel PK, and then, the second nozzle member 272 is attached. Furthermore, a recess portion 259 for positioning the support mechanism 258 supporting the second optical element LS2 is formed in part of the outer marginal portion of the second nozzle member 272. By doing so, also when the second nozzle member 272 is attached to the lower-end portion of the barrel PK, the second nozzle member 272 is prevented from interfering with the support mechanism 258.

Although not shown in the figure, the second nozzle member 272 for supporting the first optical element LS1 and the barrel PK are connected with a plurality of bolt members. The bolt members are provided at a plurality of predetermined positions along the circumferential direction of the second nozzle member 272. Furthermore, washer members are provided so as to correspond to the bolt members. The washer members function as spacer members disposed between the upper surface of the second nozzle member 272 and the lower surface of the barrel PK and function as an adjustment mechanism for adjusting the positional relationship between the second nozzle member 272 and the barrel PK and eventually, the positional relationship between the second optical element LS2 supported on the barrel PK (the support mechanism 258) and the first optical element LS1 supported on the second nozzle member 272. The positional relationship between the second optical element LS2 and the first optical element LS1 includes the relative distance or the relative inclination between the lower surface T3 of the second optical element LS2 and the upper surface T2 of the first optical element LS1. The spacer members (washer members) are supported at predetermined angular intervals on the upper surface of the second nozzle member 272. The positional relationship can be adjusted by changing, as appropriate, the thickness of the spacer member (washer member) to be used or changing, as appropriate, the number of layers of the spacer members (washer members). Then, the second nozzle member 272 and the barrel PK are secured with bolts such that spacer members (washer members) are disposed between the upper surface of the second nozzle member 272 and the lower surface ofthe barrel PK.

In FIG. 26 to FIG 28, each of the peripheral region, facing the predetermined surface 279 of the second nozzle member 272, of the upper surface T2 of the first optical element LS1 and the region, opposing the collection member 255, on the lower surface of the flange portion F1 of the first optical element LS1 is liquid-repellent (water-repellent) to the liquid LQ. Furthermore, on the second optical element LS2, the region opposing the second nozzle member 272 and the region opposing the barrel PK are also liquid-repellent (water-repellent) to the liquid LQ. In addition, in the second nozzle member 272, regions opposing the second optical element LS2, such as the predetermined surface 279, are also liquid-repellent (water-repellent) to the liquid LQ. Furthermore, in the collection member 255, the region opposing the flange portion F1 of the first optical element LS1 is also liquid-repellent (water-repellent) to the liquid LQ.

Liquid-repellency treatment for endowing these members with liquid-repellent property includes treatment such as applying liquid-repellent materials, for example, fluorocarbon resin material (including fluorocarbon rubber) such as polytetrofluroethelene (Teflon (registered trademark)), acrylic resin material, silicon resin material, and poly ether ether ketone (PEEK). Alternatively, the collection member 255 may be formed of material having liquid-repellent property, for example, fluorocarbon resin such as PTFE (polytetrafluroethelene), PFA (tetrafluoroethylene-perfluoroalkoxy ethylene copolymer) or PEEK.

The liquid LQ held between the upper surface T2 of the first optical element LS 1 and the lower surface T3 of the second optical element LS2 can be prevented from entering the gap G12 or leaking outside via the gap G12 by setting the gap G12 to a predetermined value (e.g., about 0.01 to 1 mm) and also by making liquid-repellent at least one of the predetermined surface 279 and the peripheral region, facing the predetermined surface 279, on the upper surface T2 of the first optical element LS1. Similarly, leakage and entrance of the liquid LQ can be prevented by making liquid-repellent each of the second optical element LS2, a predetermined region on the surface of the second nozzle member 272, and a predetermined region on the surface of the collection member 255.

Furthermore, the liquid LQ is prevented from leaking outside via a gap G14 between the lower surface of the flange portion F1 of the first optical element LS1 and the collection member 255 by setting the gap G14 to a predetermined value (e.g., about 0.01 to 1 mm).

For example, the side surface of the flange portion F1 of the first optical element LS1 may be liquid-repellent, a predetermined region other than the above-described region on the surface of the second nozzle member 272 may be liquid-repellent, and the entire surface of the second nozzle member 272 may be liquid-repellent. Similarly, on the surface of the collection member 255, a predetermined region other than the above-described region may be liquid-repellent, and the entire surface of the collection member 255 may be liquid-repellent.

Next, a method of exposing a pattern image of the mask M onto the substrate P using the exposure apparatus EX with the above-described structure will be described.

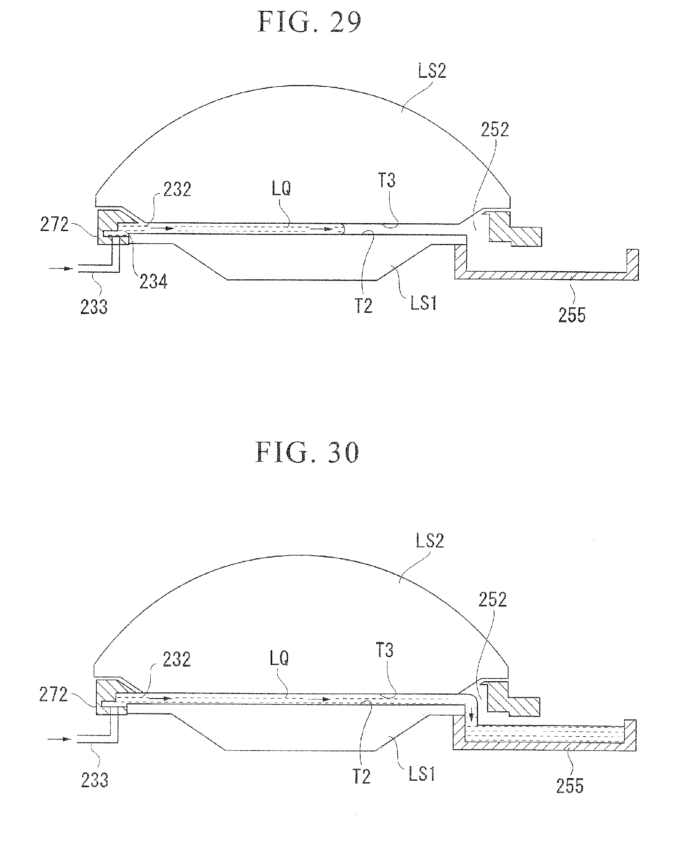

As shown in the schematic diagram of FIG. 29, in order to subject the substrate P to immersion exposure, the control apparatus CONT sends the liquid LQ from the second liquid supply apparatus 231 of the second immersion mechanism 202 and supplies the liquid LQ to the upper surface T2 side of the first optical element LS1 via the supply outlet 232 so that the predetermined region AR2 through which the exposure light EL passes on the upper surface T2 of the first optical element LS1 forms the second immersion region LR2. Before the second liquid supply apparatus 231 of the second immersion mechanism 202 starts sending the liquid LQ, the liquid LQ does not exist in the second space K2. In the following description, the operation of supplying the liquid LQ to an optical path space (the second space K2) in which the liquid LQ does not exist in order to fill the optical path space with the liquid LQ is referred to as "initial filling operation" as appropriate. In short, the initial filling operation refers to the operation of supplying the liquid LQ to an optical path space not including the liquid LQ (empty state) to fill the optical path space with the liquid LQ.

When the liquid LQ is sent from the second liquid supply apparatus 231 under the control of the control apparatus CONT in order to apply initial filling to the second space K2, the liquid LQ sent from the second liquid supply apparatus 231 flows through the supply pipe 233 and is then supplied to the upper surface T2 side of the first optical element LS1 from the supply outlet 232 via the supply passage 234 formed inside the second nozzle member 272.

When the second liquid supply apparatus 231 of the second immersion mechanism 202 continues, for a predetermined period of time, the operation of supplying a predetermined amount of liquid LQ per unit of time from the supply outlet 232, the liquid LQ is supplied to between the upper surface T2 of the first optical element LS1 and the lower surface T3 of the second optical element LS2. Thereafter, by further continuing the liquid supply operation by the second liquid supply apparatus 231, the liquid LQ in the second space K2 is partially discharged from the discharge outlet 252 due to gravity, as shown in FIG. 30. In this embodiment, since the liquid LQ is supplied to the upper surface T2 side of the first optical element LS 1 from the supply outlet 232 disposed outside the predetermined region AR2 and the liquid LQ is discharged from the discharge outlet 252 disposed at the opposite side of the predetermined region AR2 from the supply outlet 232, the liquid LQ can smoothly flow along the upper surface T2 of the first optical element LS1. Therefore, the second space K2 can be filled with the liquid LQ satisfactorily while preventing bubbles from being generated. Furthermore, since the liquid LQ is discharged via the discharge outlet 252 due to gravity, the liquid LQ can be prevented from entering, for example, a gap G13 between the second optical element LS2 and the second nozzle member 272 (refer to FIG. 27 and FIG. 28) and the liquid LQ can be prevented from leaking outside the second space K2 via the gap G13. In addition, in this embodiment, since the upper-end portion of the discharge outlet 252 is provided at a position substantially the same height as or lower than the predetermined region AR2 on the upper surface T2 of the first optical element LS1, the liquid LQ can be discharged smoothly.

When the liquid LQ is supplied from the supply outlet 232 to the second space K2, the liquid LQ that has not been discharged successfully from the discharge outlet 252 may enter the gap G13 provided at a position higher than the second space K2. However, since the collection ports 242 are provided on the inside face 272T of the second nozzle member 272, the second immersion mechanism 202 can recover the liquid LQ that has entered the gap G13 via the collection ports 242.

In this embodiment, the control apparatus CONT continues to drive the second liquid recovery apparatus 241 while the liquid LQ is being supplied from the supply outlet 232 to fill the second space K2 with the liquid LQ. In short, during initial filling operation, liquid supply operation of the second liquid supply apparatus 231 and driving the second liquid recovery apparatus 241 are performed in parallel. As a result of the second liquid recovery apparatus 241 being driven, the liquid LQ that has entered the gap G13 from the second space K2 flows into the recovery passage 244 of the second nozzle member 272 via the collection ports 242 and is recovered by the second liquid recovery apparatus 241 via the recovery pipe 243.

Furthermore, since the liquid LQ supplied from the supply outlet 232 flows towards the discharge outlet 252, there is high possibility that the liquid LQ enters the gap G13 adjacent to the discharge outlet 252. However, since the collection ports 242 are provided on the opposite side of the predetermined region AR2 from the supply outlet 232, that is, adjacent to the discharge outlet 252, the liquid LQ that has entered the gap G13 can be recovered smoothly via the collection ports 242.

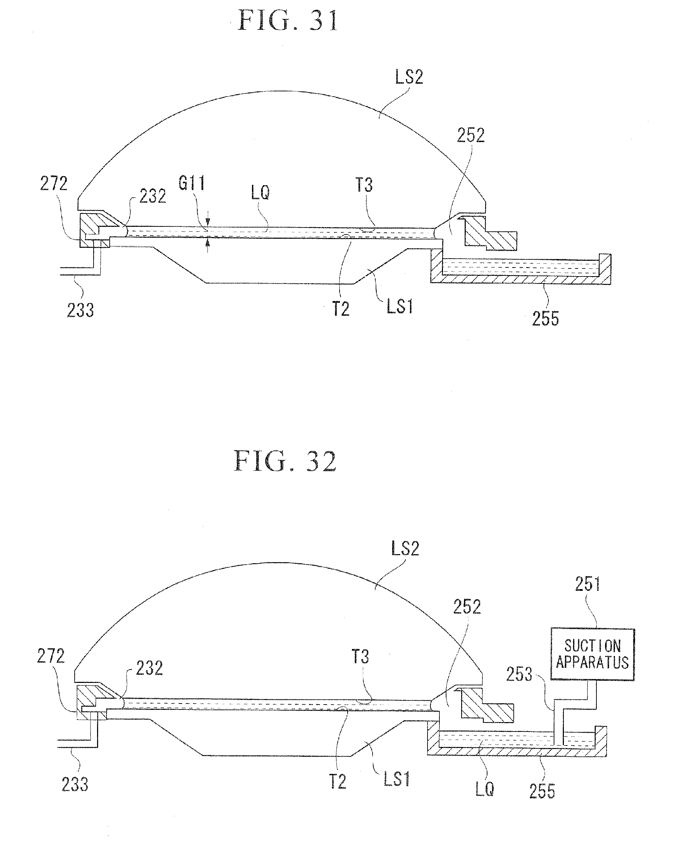

After the second space K2 has become full of the liquid LQ, the control apparatus CONT stops the liquid supply operation of the second liquid supply apparatus 231. At least the predetermined region AR2 through which the exposure light EL passes on the upper surface T2 of the first optical element LS1 and the lower surface T3 of the second optical element LS2 are lyophilic with the liquid LQ, and the gap G11 between the upper surface T2 of the first optical element LS and the lower surface T3 of the second optical element LS2 is set to, for example, about 1 mm. Therefore, even when the liquid supply operation of the second liquid supply apparatus 231 is stopped, the liquid LQ is held between the upper surface T2 of the first optical element LS1 and the lower surface T3 of the second optical element LS2 due to surface tension, as shown in FIG. 31.

Furthermore, the control apparatus CONT supplies a predetermined amount of liquid LQ onto the substrate P using the first liquid supply apparatus 211 of the first immersion mechanism 201 and recovers a predetermined amount of liquid LQ on the substrate P using the first liquid recovery apparatus 221 to fill the first space K1, which is an optical path space of the exposure light EL, between the projection optical system PL and the substrate P, with the liquid LQ and locally form the first immersion region LR1 of the liquid LQ on the substrate P. When the first immersion region LR1 of the liquid LQ is to be formed, the control apparatus CONT drives each of the first liquid supply apparatus 211 and the first liquid recovery apparatus 221. When the liquid LQ is sent from the first liquid supply apparatus 211 under the control of the control apparatus CONT, the liquid LQ sent from the first liquid supply apparatus 211 flows through the supply pipe 213 and is then supplied to the image-plane side of the projection optical system PL from the supply outlet 212 via the supply passage 214 formed inside the first nozzle member 271. Furthermore, when the first liquid recovery apparatus 221 is driven under the control of the control apparatus CONT, the liquid LQ on the image-plane side of the projection optical system PL flows into the recovery passage 224 formed inside the first nozzle member 271 via the collection port 222, flows though the recovery pipe 223, and is then recovered by the first liquid recovery apparatus 221.

After the first space K1 and the second space K2 have been filled with the liquid LQ, the control apparatus CONT illuminates the mask M held on the mask stage MST with the exposure light EL by the illumination optical system IL. The exposure light EL emitted from the illumination optical system IL passes through the mask M, each of the plurality of the optical elements LS7 to LS3, a predetermined region on the upper surface T4 of the second optical element LS2, and a predetermined region on the lower surface T3 and is then incident upon the second immersion region LR2. The exposure light EL that has passed through the second immersion region LR2 passes through a predetermined region on the upper surface T2 of the first optical element LS1 and a predetermined region on the lower surface T1, is incident upon the first immersion region LR1, and then reaches the substrate P. In this manner, the substrate P is subjected to immersion exposure.

In this embodiment, at least while the exposure light EL is emitted onto the substrate P, the control apparatus CONT performs supply operation of the liquid LQ and recovery operation of the liquid LQ in parallel using the first immersion mechanism 201. By doing so, even if impurities (e.g., resist) from the substrate P are mixed, for example, into the liquid LQ of the first immersion region LR1, a clean liquid LQ is supplied from the supply outlet 212, and the liquid LQ in contact with the substrate P is recovered from the collection port 222. Therefore, the first space K1 is always filled with a clean and temperature-managed liquid LQ.

Furthermore, in this embodiment, at least while the exposure light EL is emitted onto the substrate P, the control apparatus CONT does not perform liquid supply operation by the second liquid supply apparatus 231 of the second immersion mechanism 202, liquid recovery operation by the second liquid recovery apparatus 241, and liquid suction-recovery operation of the collection member 255 by the suction apparatus 251. In other words, in this embodiment, the exposure light EL is emitted onto the substrate P while the second space K2 is filled with the liquid LQ. Vibration may occur in some cases along with supply operation and recovery operation of the liquid LQ. However, since liquid supply operation by the second liquid supply apparatus 231 of the second immersion mechanism 202, liquid recovery operation by the second liquid recovery apparatus 241, and liquid suction-recovery operation of the collection member 255 by the suction apparatus 251 are not performed at least while the exposure light EL is emitted onto the substrate P, vibration resulting from the operation of the second immersion mechanism 202 does not occur during exposure of the substrate P. Therefore, the substrate P can be exposed with high accuracy.

Furthermore, the control apparatus CONT performs replacement operation of the liquid LQ in the second space K2, for example, at predetermined intervals or every predetermined number of substrates that have been processed (e.g., every lot). When performing replacement of the liquid LQ in the second space K2, the control apparatus CONT supplies a predetermined amount of liquid LQ to the second space K2 from the second liquid supply apparatus 231 via the supply outlet 232. In addition, when the liquid LQ in the second space K2 is to be replaced, the second liquid recovery apparatus 241 is also driven in parallel with the liquid supply operation of the second liquid supply apparatus 231. By doing so, not only is the liquid LQ existing in the second space K2 discharged from the discharge outlet 252, but also the second space K2 is filled with a new (clean) liquid LQ supplied from the supply outlet 232.

As shown in FIG. 32, the control apparatus CONT drives the suction apparatus 251 when a predetermined amount of liquid LQ is collected in the collection member 255 or at predetermined intervals or every predetermined number of substrates that have been processed. As described above, the control apparatus CONT drives the suction apparatus 251 while the exposure light EL is not emitted onto the substrate P. As a result of the suction apparatus 251 being driven, the liquid LQ in the collection member 255 is suction-recovered by the suction apparatus 251 via the suction pipe 253. By doing so, problems such that the liquid LQ leaks from the collection member 255 or the liquid LQ in the collection member 255 flows back into the second space K2 can be prevented. Alternatively, a water-level sensor may be attached to the collection member 255 so that suction-recovery by the suction apparatus 251 is performed when the liquid LQ in the collection member 255 reaches a predetermined amount.

As described above, the predetermined region AR2 on the upper surface T2 of the first optical element LS1 can be made to serve as the second immersion region LR2 with the liquid LQ supplied from the supply outlet 232. Furthermore, since the liquid LQ in the second space K2 is discharged from between the first optical element LS 1 and the second nozzle member 272, the liquid LQ can be discharged smoothly. Therefore, the liquid LQ in the second space K2 and the second optical element LS2 in contact with the liquid LQ can be kept in a clean state, and hence the substrate P can be exposed with high accuracy.

In other words, the liquid LQ can be discharged while being prevented from entering, for example, the gap G13 between the second optical element LS2 and the second nozzle member 272 by discharging the liquid LQ via the discharge outlet 252 due to gravity. If the liquid LQ enters the gap G13 between the second optical element LS2 and the second nozzle member 272, the force of the liquid LQ is applied to the side surface of the second optical element LS2, thus possibly moving or deforming the second optical element LS2. In addition, even if a sealing member, such as an O-ring, a V-ring, or a C-ring, is provided in the gap G13 to prevent the liquid LQ from entering the gap G13, there is danger that the second optical element LS2 is moved or deformed by the sealing member. Furthermore, if an attempt is made to make the gap G13 small enough to prevent the liquid LQ from entering the gap G13, entrance of the liquid LQ into the gap G13 causes the liquid LQ to be held in the gap G13, thus contaminating the liquid LQ and allowing, for example, bacteria (live bacteria) to occur. If the liquid LQ is contaminated, members in contact with the liquid LQ, such as the first and second optical elements LS1 and LS2 and the second nozzle member 272, may also be contaminated. Furthermore, there is possibility of a problem such that the liquid LQ enters or leaks into a space outside the second space K2 (e.g., the space above the second optical element LS2) via the gap G13 between the second optical element LS2 and the second nozzle member 272. In addition, bubbles may be generated in the liquid LQ held in the second space K2 as a result of the liquid LQ entering the gap G13 and flowing out of the gap G13.

In this embodiment, since the liquid LQ is discharged from the discharge outlet 252 due to gravity before entering, for example, the gap G13 between the second optical element LS2 and the second nozzle member 272, the occurrence of the above-described problem can be suppressed.

Furthermore, even if the liquid LQ enters the gap G13 while the liquid LQ is supplied to the second space K2 from the supply outlet 232, the liquid LQ can be recovered via the collection port 242 since the collection port 242 is formed on the inside face 272T of the second nozzle member 272 in which the gap G13 is formed.

In addition, since the collection member 255 for collecting the liquid LQ discharged from the discharge outlet 252 is provided, the liquid LQ can be collected without driving the suction apparatus 251 or the second liquid recovery apparatus 241, for example, during exposure of the substrate P.

### <Fifth Embodiment>

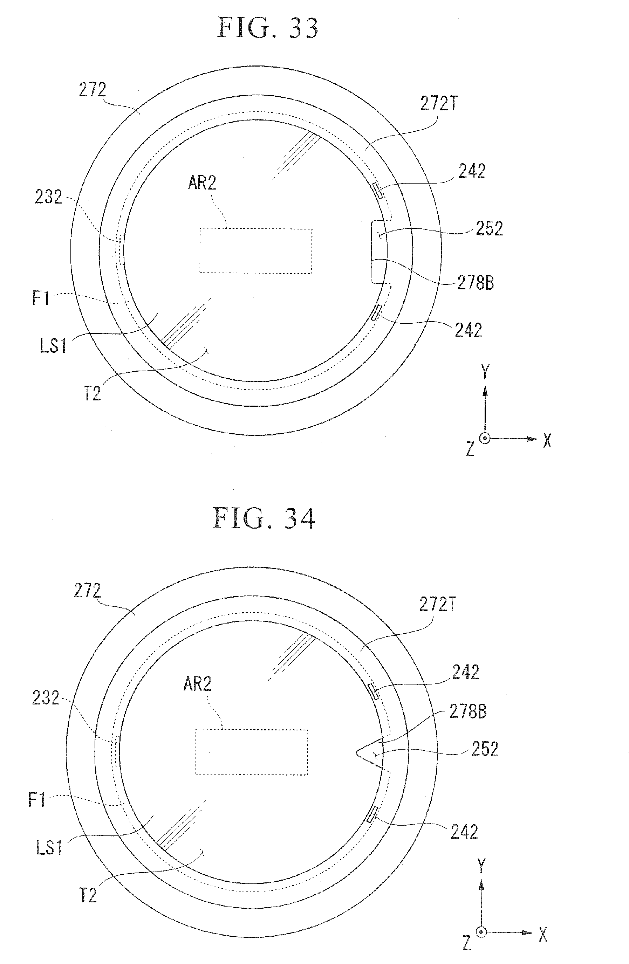

A fifth embodiment will be described with reference to FIG. 33. In the following description, components same as or equivalent to those in the above-described fourth embodiment will be denoted by the same reference numerals and described only briefly, or a description thereof will be omitted.

In FIG. 33, the cut portion 278B is formed in the flange portion F1 of the first optical element LS1. The cut portion 278B is formed in a "U" shape in plan view. The discharge outlet 252 formed between the first optical element LS 1 and the second nozzle member 272 includes the cut portion 278B of the first optical element LS1. On the other hand, no cut portion is provided in the second nozzle member 272. In this manner, the cut portion may be formed only in the first optical element LS1.

### <Sixth Embodiment>

A sixth embodiment will be described with reference to FIG. 34. In FIG 34, the cut portion 278B is formed in the flange portion F1 of the first optical element LS1. The cut portion 278B is formed in a V-groove shape in plan view. The discharge outlet 252 formed between the first optical element LS1 and the second nozzle member 272 includes the cut portion 278B of the first optical element LS1. On the other hand, no cut portion is provided in the second nozzle member 272. In this manner, the cut portion may be formed in a V-groove shape. Alternatively, the cut portion can be any shape, such as an arc shape.

Alternatively, the fourth to sixth embodiments may be constructed so that the cut portion is provided only in the second nozzle member 272, that is, no cut portion is provided in the first optical element LS1. Furthermore, when a cut portion is to be provided in the second nozzle member 272, the cut portion can be any shape, such as a V- groove shape as shown in FIG. 34 or an arc shape. In addition, a through-hole may be provided in the second nozzle member 272 so that the liquid LQ2 in the second space K2 is discharged via this through-hole.

In the fourth to sixth embodiments, a cut portion is provided in at least one of the outer marginal portion of the first optical element LS1 and the second nozzle member 272. Instead, without providing a cut portion, the liquid LQ in the second space K2 may be discharged via the gap between the first optical element LS1 and the second nozzle member 272.

### <Seventh Embodiment>

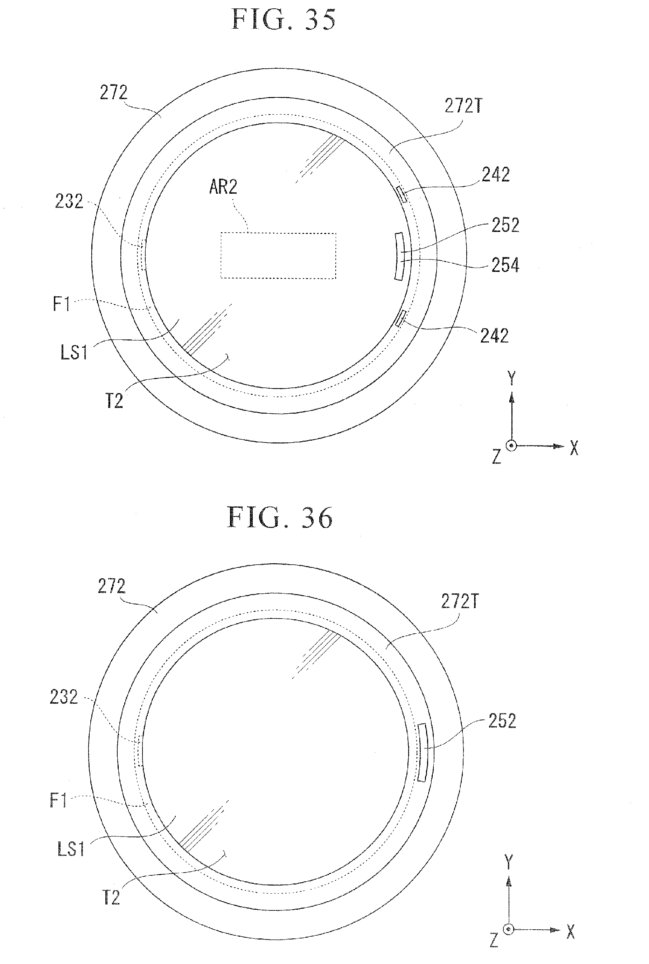

A seventh embodiment will be described with reference to FIG. 35. In FIG. 35, the through-hole (discharge passage) 254 that passes through the flange portion F1 of the first optical element LS1 is formed at a predetermined position of this flange portion F1, and the upper-end portion of this through-hole 254 serves as the discharge outlet 252 for discharging the liquid LQ in the second space K2. In this manner, the discharge outlet 252 may be provided in a region, on the upper surface T2 of the first optical element LS1, other than the predetermined region AR2 through which the exposure light EL passes.

### <Eighth Embodiment>

An eighth embodiment will be described with reference to FIG. 36. In FIG 36, the discharge outlet 252 for discharging the liquid LQ in the second space K2 is formed at a predetermined position on the inside face 272T (or the upper surface) of the second nozzle member 272. In this manner, the discharge outlet 252 may be provided at part of the second nozzle member 272. In this case, the surface (region), where the discharge outlet 252 is formed, on the second nozzle member 272 is preferably provided at a position substantially the same height as or lower than the upper surface T2 (the predetermined region AR2) of the first optical element LS 1.

### <Ninth Embodiment>

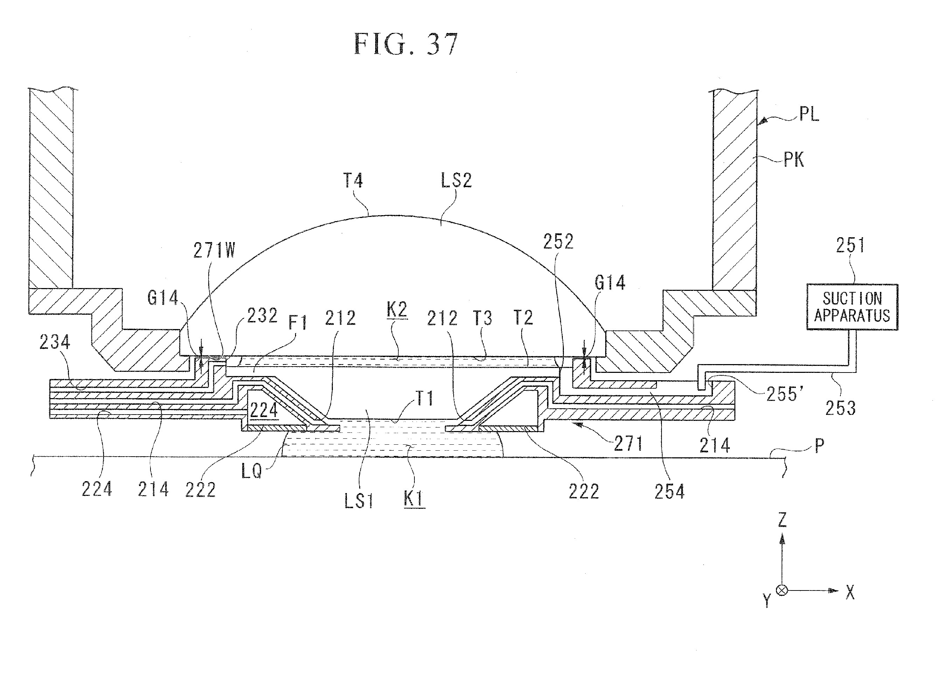

A ninth embodiment will be described with reference to FIG. 37. In this embodiment, the first optical element LS1 is supported by the first nozzle member 271. Also, the first nozzle member 271 includes the supply outlet 212 for filling the first space K1 with the liquid LQ; the collection port 222; and the supply outlet 232 for filling the second space K2 with the liquid LQ. Furthermore, the first nozzle member 271 of this embodiment has a function as a collection member for collecting the liquid LQ discharged from the second space K2.

A support mechanism (not shown in the figure) for supporting the first optical element LS1 is provided in the first nozzle member 271, and the flange portion F1 of the first optical element LS 1 is supported by the support mechanism provided in the first nozzle member 271. The first nozzle member 271 has a frame portion 271W enclosing the first optical element LS1, and in this embodiment, a support mechanism for supporting the first optical element LS1 is provided on the upper surface of the frame portion 271W or the first nozzle member 271. Furthermore, at the frame portion 271 W of the first nozzle member 271, the supply outlet 232 for supplying the liquid LQ to the second space K2 (the predetermined region AR2) is provided on the -X side of the second space K2. On the other hand, at the frame portion 271W of the first nozzle member 271, the discharge outlet 252 for discharging the liquid LQ in the second space K2 (the predetermined region AR2) is provided on the +X side of the second space K2. The discharge outlet 252 is connected to a collection portion 255' via the discharge passage 254 formed inside the first nozzle member 271. The liquid LQ discharged from the discharge outlet 252 is collected in the collection portion 255'. The liquid LQ collected in the collection portion 255' is suction-recovered by the suction apparatus 251 via the suction pipe 253.

Furthermore, the discharge passage 254 is not completely filled with the liquid LQ, and the second space K2 communicates with the external space (atmospheric space) via the discharge passage 254. In other words, the second space K2 is open to the atmosphere via the discharge passage 254. By doing so, the liquid LQ in the second space K2 can be discharged via the discharge outlet 252 smoothly. In the figure, the gap G14 is formed between the upper surface of the frame portion 271 W of the first nozzle member 271 and the lower surface T3 of the second optical element LS2. However, a sealing member may be provided in the gap G14.

As described above, it is possible not only to omit the second nozzle member 272 and support the first optical element LS1 by the first nozzle member 271 but also to provide the supply outlet 232 for supplying the liquid LQ to the second space K2 in the first nozzle member 271. Then, the discharge outlet 252 can be provided between the first optical element LS1 and the first nozzle member 271 (the frame portion 271W). With such a structure, the overall size of the exposure apparatus EX can be reduced (the space can be saved).

In the fourth to ninth embodiments, the suction apparatus 251 has been described as being driven when the liquid LQ in the collection member 255 (the collection portion 255') reaches a predetermined amount or at predetermined intervals or every predetermined number of substrates that have been processed. However, suction-recovery operation of the liquid LQ by the collection member 255 may be performed in parallel with liquid supply operation of the second liquid supply apparatus 231 at the time of initial filling operation and replacement operation of the liquid LQ in the second space K2. In other words, the control apparatus CONT can concurrently perform the driving of the second liquid supply apparatus 231 and the driving of the suction apparatus 251 at the time of at least initial filling operation and replacement operation of the liquid LQ in the second space K2.

In the fourth to ninth embodiments, liquid supply operation by the second liquid supply apparatus 231 of the second immersion mechanism 202, liquid recovery operation by the second liquid recovery apparatus 241, and liquid suction-recovery operation of the collection member 255 by the suction apparatus 251 are performed as required at the time of initial filling operation or replacement operation of the liquid LQ in the second space K2, whereas liquid supply operation by the second liquid supply apparatus 231 of the second immersion mechanism 202, liquid recovery operation by the second liquid recovery apparatus 241, and liquid suction-recovery operation of the collection member 255 by the suction apparatus 251 are not performed while the exposure light EL is emitted onto the substrate P. However, at least part of the second liquid supply apparatus 231, the second liquid recovery apparatus 241, and the collection member 255 of the second immersion mechanism 202 may be driven as appropriate during exposure of the substrate P as long as the level of vibration resulting from, for example, liquid supply operation by the second liquid supply apparatus 231, liquid recovery operation by the second liquid recovery apparatus 241, and liquid suction-recovery operation of the collection member 255 by the suction apparatus 251 is equal to or below a permissible level. For example, supply operation of the liquid LQ by the second liquid supply apparatus 231 may be performed continuously during exposure of the substrate P. When liquid supply operation of the second liquid supply apparatus 231 is performed, the second liquid recovery apparatus 241 and the suction apparatus 251 are driven in parallel with liquid supply operation of the second liquid supply apparatus 231. By doing so, a clean and temperature-managed liquid LQ is always supplied to the second space K2 from the second liquid supply apparatus 231 via the supply outlet 232.

In the fourth to ninth embodiments, the numbers and arrangements of supply outlets 232, discharge outlets 252, and collection ports 242 can be changed as appropriate. For example, a plurality of the discharge outlets 252 may be provided, and furthermore, a plurality of the supply outlets 232 may be provided. Furthermore, the collection ports 242 may be provided at positions far away from the discharge outlet 252 or may be provided at a plurality of predetermined positions so as to enclose the second space K2.

In the above-described embodiments, the opening 255K is provided at the upper part of the collection member 255, and the suction pipe 253 is disposed in the opening 255K. Alternatively, the other end portion of the suction pipe 253 may be connected, for example, to the bottom portion of the collection member 255.

The recovery pipe 243 and the second liquid recovery apparatus 241 shown in FIG. 28 may be provided at the recess portion 75 of the first embodiment so that the second liquid LQ2 that has leaked into the recess portion 75 can be discharged via these recovery pipe 243 and second liquid recovery apparatus 241.

Furthermore, instead of the liquid collector 68 disposed below the through-hole 65 of the first embodiment, the collection member and suction apparatus described in the fourth to ninth embodiments may be provided.

As described above, one or more of the components in one embodiment can be combined or replaced with another embodiment.

In each of the above-described embodiments, a structure where supply and recovery of the second liquid LQ2 are not performed during exposure of the substrate P has been described. However, supply and recovery of the second liquid LQ2 may be performed also during exposure of the substrate P as long as vibration accompanied by supply and recovery of the second liquid LQ2 does not adversely affect the exposure accuracy.

In each ofthe above-described embodiments, the first optical element LS1 is a plane-parallel plate, and therefore, replacement of the first optical element LS1 rarely affects the aberration of the projection optical system PL. However, the first optical element LS1 may have curvature (refractive power) as long as replacement of the first optical element LS1 does not affect aberration of the projection optical system PL.

Although the discharge outlet 252 is disposed on the +X side of the predetermined region AR2 in the fourth to ninth embodiments, it may be provided on the +Y side or -Y side of the predetermined region AR2.

Although the fourth to ninth embodiments have been described such that the entire collection port 242 is provided at a position higher than the upper surface T2 of the first optical element LS1, the upper end of the collection port 242 may be provided at a position higher than the upper surface T2 of the first optical element LS1, and the lower end of the collection port 242 may be provided at a position lower than the upper surface T2 of the first optical element LS1. Doing so is preferable because the liquid LQ can be recovered smoothly.

In the fourth to ninth embodiments, the nozzle members (the first and second nozzle members) are formed in substantially annular shapes (toric shapes). However, the nozzle members can be any shape, such as a rectangular shape. Similarly, the porous members are not limited to an annular shape in plan view but may be formed in a rectangular shape in plan view. Furthermore, the first liquid supply mechanism and the second liquid supply mechanism in each of the present embodiments can adjust the temperatures of liquids independently.

The liquids LQ1, LQ2, and LQ in each of the above-described present embodiments are formed of pure water. Pure water has advantages in that it can be easily obtained in large quantity at semiconductor manufacturing plants, etc. and in that it has no adverse effects on the photoresist on the substrate P or on the optical elements (lenses), etc. In addition, pure water has no adverse effects on the environment and contains very few impurities, so one can also expect an action whereby the surface of the substrate P and the surface of the optical element provided on the front end surface of the projection optical system PL are cleaned. In the case where pure water supplied from plants, etc. has a low degree of purity, the exposure apparatus may have an extra pure water production apparatus.

In addition, the index of refraction n of pure water (water) with respect to the exposure light EL with a wavelength of about 193 nm is nearly 1.44, so in the case where ArF excimer laser light (193 nm wavelength) is used as the light source of the exposure light EL, it is possible to shorten the wavelength to 1/n, that is, approximately 134 nm on the substrate P, to obtain high resolution. Also, the depth of focus is expanded by approximately n times, that is approximately 1.44 times, compared with it being in air, so in the case where it would be permissible to ensure the same level of depth of focus as the case in which it is used in air, it is possible to further increase the numerical aperture of the projection optical system PL, and resolution improves on this point as well.

If the liquid immersion method is used as described above, the numerical aperture NA of the projection optical system may be 0.9 to 1.3. In this manner, if the numerical aperture NA of the projection optical system becomes large, it is preferable that polarizing illumination be used because randomly polarized light, which has been used conventionally as exposure light, may degrade the imaging performance due to polarization effect. In this case, linearly polarizing illumination in accordance with the longitudinal direction of the line pattern of the line-and-space pattern of the mask (reticle) should be performed so that a large amount of diffracted light of the S-polarization component (TE-polarization component), that is, the polarization direction component along the longitudinal direction of the line pattern is emitted from the pattern of the mask (reticle). In the case where liquid is held between the projection optical system PL and the resist applied to the substrate P surface, the transmissivity, on the resist surface, of diffracted light of the S-polarization component (TE-polarization component) contributing to enhancement in the contrast becomes high, compared with the case where air (gas) is held between the projection optical system PL and the resist applied to the substrate P surface. Therefore, even if the numerical aperture NA of the projection optical system exceeds 1.0, high imaging performance can be obtained. An appropriate combination of, for example, the phase shift mask and the oblique-incidence illumination method (in particular, the dipole illumination method) in accordance with the longitudinal direction of the line pattern, as disclosed in Japanese Unexamined Patent Application, First Publication No. H6-188169, will be further effective. In particular, the combination between the linear-polarization-illumination method and the dipole illumination method is effective if the period direction of the line-and-space pattern is limited to a predetermined one direction or the hole pattern is dense in a predetermined one direction. For example, in the case where a half-tone phase-shift mask with a transmissivity of 6% (a pattern with a half pitch of about 45 nm) is to be illuminated using the linear-polarization-illumination method together with the dipole illumination method, the depth of focus (DOF) can be increased by about 150 nm compared with the case where randomly polarized light is used, if the value of illumination σ specified by the circumcircle of two beams forming a dipole on the pupil plane of the illumination system is 0.95, the radius of each beam on the pupil plane is 0.125σ, and the numerical aperture of the projection optical system PL is NA=1.2.

Furthermore, the combination of linearly polarizing illumination and an illumination method with a small σ (an illumination method with a value σ of 0.4 or less, where σ indicates the ratio between the numerical aperture NAi of the illumination system and the numerical aperture NAp of the projection optical system) is also effective.

In addition, if, for example, ArF excimer laser is used as exposure light and fine line-and-space patterns (e.g., about 25 to 50 nm lines and spaces) are to be exposed onto the substrate P using the projection optical system PL with a reduction magnification of about 1/4, the mask M works as a polarizer due to the wave guide effect depending on the structure of the mask M (e.g., fineness of the pattern and thickness of chromium), thus emitting more diffracted light of the S-polarization component (TE-polarization component) from the mask M than diffracted light of the P-polarization component (TM-polarization component) which decreases the contrast. In this case, it is preferable that the above-described linearly polarizing illumination be used. However, if the mask M is illuminated with randomly polarized light and the numerical aperture NA of the projection optical system PL is as large as 0.9 to 1.3, high resolving performance can be obtained.

In addition, when super fine line-and-space patterns on the mask M are to be exposed onto the substrate P, there is possibility that the P-polarization component (TM-polarization component) becomes stronger than the S-polarization component (TE-polarization component) due to the wire grid effect. However, if, for example, ArF excimer laser is used as exposure light and line-and-space patterns larger than 25 nm are to be exposed onto the substrate P using the projection optical system PL with a reduction magnification of about 1/4, more diffracted light of the S-polarization component (TE-polarization component) is emitted from the mask M than diffracted light of the P-polarization component (TM-polarization component). Therefore, high resolving performance can be obtained even if the numerical aperture NA of the projection optical system PL is as large as 0.9 to 1.3.

Furthermore, not only linearly polarizing illumination (S polarizing illumination) in accordance with the longitudinal direction of the line patterns of the mask (reticle) but also the combination of a polarizing illumination method for linearly polarizing in the tangent (circumferential) direction of a circle with its center as the optical axis and the oblique-incidence illumination method is also effective, as disclosed in Japanese Unexamined Patent Application, First Publication No. H6-53120. In particular, if line patterns extending in a plurality of different directions, as well as line patterns of patterns extending in a predetermined one direction, on the mask (reticle) are mixed (line-and-space patterns with different period directions are mixed), high imaging performance can be obtained even if the numerical aperture NA of the projection optical system is large by using a polarizing illumination method for linearly polarizing in the tangent direction of a circle with its center as the optical axis together with an annular illumination method, as disclosed in the same Japanese Unexamined Patent Application, First Publication No. H6-53120. For example, in the case where a half-tone phase-shift mask with a transmissivity of 6% (a pattern with a half pitch of about 63 nm) is to be illuminated by using a polarizing illumination method for linearly polarizing in the tangent direction of a circle with its center as the optical axis together with an annular illumination method (annular ratio of 3/4), the depth of focus (DOF) can be increased by about 250 nm if the value of the illumination σ is 0.95 and the numerical aperture of the projection optical system PL is NA=1.00 compared with the case where randomly polarized light is used, and furthermore, the depth of focus can be increased by about 100 nm with a pattern having a half pitch of about 55 nm and the numerical aperture NA=1.2 of the projection optical system.

Furthermore, in addition to the above-described various illumination methods, employing a progressive focus exposure method, as disclosed in, for example, Japanese Unexamined Patent Application, First Publication No. H4-277612 and Japanese Unexamined Patent Application, First Publication No. 2001-345245, and a multi-wavelength exposure method that can provide the same effect as with the progressive focus exposure method using exposure light of multi-wavelength (e.g., dual wavelength) is also effective.

In the above embodiments, the optical element LS 1 is attached to the front end of the projection optical system PL, and this optical element can be used to adjust the optical characteristics, for example, the aberration (spherical aberration, coma aberration, etc.), of the projection optical system PL. Note that an optical plate used for the adjustment of the optical characteristics of the projection optical system PL may also be used as the optical element attached to the front end of the projection optical system PL. Or, it may also be a plane-parallel plate through which the exposure light EL is able to pass.

In the case where the pressure between the substrate P and the optical element of the front end of the projection optical system PL arising from the flow of the liquids LQ1, LQ2, and LQ is large, it is permissible to make that optical element not one that is replaceable but one that is firmly secured so that the optical element does not move due to that pressure.

In the above embodiments, the configuration is one in which the liquids LQ1, LQ2, and LQ are filled between the projection optical system PL and the surface of the substrate P, but it may also be a configuration in which the liquids LQ1, LQ2, and LQ are filled in a status in which a cover glass consisting of a plane-parallel plate is attached to the surface of the substrate P, for example.

Note that the liquids LQ1, LQ2, and LQ of the above embodiments are water, but they may be liquids other than water. For example, if the light source of the exposure light EL is an F2 laser, this F2 laser light will not pass through water, so the liquids LQ1, LQ2, and LQ may be, for example, a fluorocarbon fluid such as a perfluoropolyether (PFPE) or a fluorocarbon oil that an F2 laser is able to pass through. In this case, the part to be in contact with the liquids LQ1, LQ2, and LQ is applied with lyophilic treatment by forming a thin film using a substance with a molecular structure that has a small polarity including fluorine. In addition, it is also possible to use, as the liquids LQ1, LQ2, and LQ, liquids that have the transmittance with respect to the exposure light EL and whose refractive index are as high as possible and that are stable with respect to the photoresist coated on the projection optical system PL and the surface of the substrate P (for example, cedar oil).

Moreover as the liquids LQ1, LQ2, and LQ, a liquid with a refractive index of 1.6 to 1.8 may be used. Furthermore, the optical element LS1 may be formed from a material with a higher refractive index than that of quartz or fluorite (for example, above 1.6).

In addition, as the liquids LQ1, LQ2, and LQ, water and liquids other than water may be mixed, so that the image-forming characteristic via the projection optical system PL and the liquids LQ1, LQ2, and LQ is controlled by controlling the mixture ratio.

It is to be noted that as for the substrate P of each of the above-described embodiments, not only a semiconductor wafer for manufacturing a semiconductor device, but also a glass substrate for a display device, a ceramic wafer for a thin film magnetic head, or a master mask or reticle (synthetic quartz or silicon wafer) used in an exposure apparatus, etc. can be used.

As for the exposure apparatus EX, in addition to a step-and-scan type exposure apparatus (scanning stepper) in which while synchronously moving the mask M and the substrate P, the pattern of the mask M is scan-exposed, a step-and-repeat type projection exposure apparatus (stepper) in which the pattern of the mask M is exposed at one time in the condition that the mask M and the substrate P are stationary, and the substrate P is successively moved stepwise can be used.

Moreover, as for the exposure apparatus EX, the present invention can be applied to an exposure apparatus of a method in which a reduced image of a first pattern is exposed in a batch on the substrate P by using the projection optical system (for example, a refractive projection optical system having, for example, a reduction magnification of 1/8, which does not include a reflecting element), in the state with the first pattern and the substrate P being substantially stationary. In this case, the present invention can be also applied to a stitch type batch exposure apparatus in which after the reduced image of the first pattern is exposed in a batch, a reduced image of a second pattern is exposed in a batch on the substrate P, partially overlapped on the first pattern by using the projection optical system, in the state with the second pattern and the substrate P being substantially stationary. As the stitch type exposure apparatus, a step-and-stitch type exposure apparatus in which at least two patterns are transferred onto the substrate P in a partially overlapping manner, and the substrate P is sequentially moved can be used.

Furthermore, the present invention can also be applied to a twin stage type exposure apparatus furnished with a plurality of substrate stages, as disclosed in Japanese Unexamined Patent Application, First Publication No. H10-163099, Japanese Unexamined Patent Application, First Publication No. H10-214783, and Published Japanese Translation No. 2000-505958 of PCT International Application.

Moreover, the present invention can also be applied to an exposure apparatus furnished with a substrate stage for holding a substrate, and a measurement stage on which is mounted a reference member formed with a reference mark, and various photoelectronic sensors, as disclosed in Japanese Unexamined Patent Application, First Publication No. H11-135400 and Japanese Unexamined Patent Application, First Publication No. 2000-164504.

Furthermore, in the above embodiments, an exposure apparatus in which the liquid is locally filled in the space between the projection optical system PL and the substrate P is used. However, the present invention can be also applied to a liquid immersion exposure apparatus in which exposure is performed in a condition with the whole surface of the target exposure substrate immersed in a liquid, as disclosed in Japanese Unexamined Patent Application, First Publication No. H6-124873, Japanese Unexamined Patent Application, First Publication No. H10-3303114, and U.S. Patent No. 5,825,043.

The types of the exposure apparatus EX are not limited to exposure apparatuses for semiconductor element manufacture that expose a semiconductor element pattern onto the substrate P, but are also widely applicable to exposure apparatuses for the manufacture of liquid crystal display elements and for the manufacture of displays, exposure apparatuses for the manufacture of thin film magnetic heads, image pickup elements (CCD), and exposure apparatuses for manufacturing reticles or masks.

In the above-mentioned embodiments, an optical transmission type mask formed with a predetermined shielding pattern (or phase pattern or dimming pattern) on an optical transmission substrate is used. However instead of this mask, for example as disclosed in U.S. Patent No. 6,778,257, an electronic mask for forming a transmission pattern or reflection pattern, or a light emitting pattern, based on electronic data of a pattern to be exposed may be used.

Furthermore the present invention can also be applied to an exposure apparatus (lithography system) which exposes a line-and-space pattern on the substrate P by forming interference fringes on the substrate P, as disclosed in PCT International Patent Publication No. WO 2001/035168.

If a linear motor is used in the substrate stage PST or the mask stage MST (refer to U.S. Patent No. 5,623,853 or U.S. Patent No. 5,528,118), then either an air levitation type that uses an air bearing or a magnetic levitation type that uses Lorentz's force or reactance force may be used. In addition, each of the stages PST and MST may be a type that moves along a guide or may be a guideless type.

For the drive mechanism of each of the stages PST and MST, a planar motor may be used that opposes a magnet unit, wherein magnets are disposed two dimensionally, to an armature unit, wherein coils are disposed two dimensionally, and drives each of the stages PST and MST by electromagnetic force. In this case, either the magnet unit or the armature unit is connected to the stages PST and MST and the other one should be provided on the plane of motion side of the stages PST and MST.

The reaction force generated by the movement of the substrate stage PST may be mechanically discharged to the floor (ground) by using a frame member so that it is not transmitted to the projection optical system PL, as recited in Japanese Unexamined Patent Application, First Publication No. H8-166475 (U.S. Patent No. 5,528,118).

The reaction force generated by the movement of the mask stage MST may be mechanically discharged to the floor (ground) by using a frame member so that it is not transmitted to the projection optical system PL, as recited in Japanese Unexamined Patent Application, First Publication No. H8-330224 (U.S. Patent No. 5,874,820).

As described above, the exposure apparatus EX of the present application embodiment is manufactured by assembling various subsystems, including the respective constituent elements presented in the Scope of Patents Claims of the present application, so that the prescribed mechanical precision, electrical precision and optical precision can be maintained. To ensure these respective precisions, performed before and after this assembly are adjustments for achieving optical precision with respect to the various optical systems, adjustments for achieving mechanical precision with respect to the various mechanical systems, and adjustments for achieving electrical precision with respect to the various electrical systems. The process of assembly from the various subsystems to the exposure apparatus includes mechanical connections, electrical circuit wiring connections, air pressure circuit piping connections, etc. among the various subsystems. Obviously, before the process of assembly from these various subsystems to the exposure apparatus, there are the processes of individual assembly of the respective subsystems. When the process of assembly to the exposure apparatuses of the various subsystems has ended, overall assembly is performed, and the various precisions are ensured for the exposure apparatus as a whole. Note that it is preferable that the manufacture of the exposure apparatus be performed in a clean room in which the temperature, the degree of cleanliness, etc. are controlled.

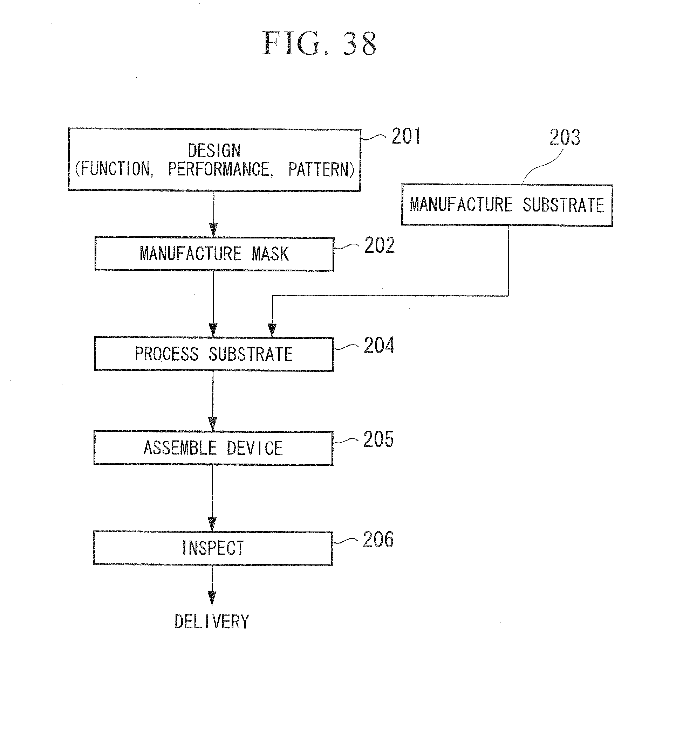

As shown in FIG. 38, microdevices such as semiconductor devices are manufactured by going through; a step 201 that performs microdevice function and performance design, a step 202 that creates the mask (reticle) based on this design step, a step 203 that manufactures the substrate that is the device base material, a step 204 including a process that exposes the pattern on the mask onto a substrate by means of the exposure apparatus EX of the aforementioned embodiments, a device assembly step (including a dicing process, a bonding process, and a packaging process) 205, and an inspection step 206, and so on.

## Claims

1. An exposure apparatus for emitting exposure light onto a substrate via a projection optical system to expose the substrate, wherein
the projection optical system comprises a first optical element that is closest to an image plane of the projection optical system and a second optical element that is closest to the image plane next to the first optical element, and
the exposure apparatus comprises a collection port that is provided at a position higher than a lower surface of the second optical element and that recovers a liquid held in a space between an upper surface of the first optical element and the lower surface of the second optical element.

2. The exposure apparatus according to Claim 1, further comprising a nozzle member provided so as to enclose a side surface of the second optical element, wherein
the collection port is provided at a position facing the side surface of the nozzle member.

3. The exposure apparatus according to Claim 2, further comprising a supply outlet that supplies a liquid to the space, wherein
the supply outlet is provided at the nozzle member.

4. The exposure apparatus according to Claim 2 or 3, wherein the nozzle member comprises a holding portion that holds the first optical element by vacuum attraction.

5. The exposure apparatus according to Claim 4, wherein the nozzle member comprises a lower surface facing a region on the upper surface of the first optical element, the region being different from a region through which the exposure light passes, and the holding portion is provided on the lower surface of the nozzle member.

6. The exposure apparatus according to any one of Claims 1 to 5, further comprising a control mechanism that controls circulation of a liquid between the space and a space outside the space.

7. The exposure apparatus according to Claim 6, wherein the second optical element comprises a first surface facing an upper surface of a nozzle member, and the sealing member is provided between the upper surface of the nozzle member and the first surface.

8. The exposure apparatus according to Claim 7, wherein a recess portion that holds a liquid leaking from the space is provided on the upper surface of the nozzle member and outside the sealing member.

9. The exposure apparatus according to any one of Claims 1 to 8, further comprising a detector that detects whether a liquid has leaked from the space.

10. The exposure apparatus according to Claim 9, wherein the detector is provided on the upper surface of the nozzle member.

11. The exposure apparatus according to Claim 9 or 10, wherein the detector comprises an optical fiber.

12. The exposure apparatus according to any one of Claims 1 to 11, further comprising a supporting member that supports the first optical element, wherein
a hole that discharges a liquid in the space is formed in the supporting member.

13. The exposure apparatus according to Claim 12, wherein the supporting member has a second surface that is lower than the upper surface of the first optical element, and the hole is provided on the second surface.

14. The exposure apparatus according to Claim 12 or 13, further comprising a gas supply system that supplies a gas to the space when a liquid is discharged from the hole.

15. An exposure apparatus for emitting exposure light onto a substrate via a projection optical system to expose the substrate, wherein
the projection optical system comprises a first optical element that is closest to an image plane of the projection optical system and a second optical element that is closest to the image plane next to the first optical element,
the exposure apparatus comprises a nozzle member that is disposed in an annular shape so as to enclose the second optical element and that has at least one of a liquid supply outlet and a liquid collection port that forms an immersion region of liquid between the first optical element and the second optical element, and
the nozzle member comprises a holding portion that holds the first optical element by vacuum attraction.

16. An exposure apparatus for emitting exposure light onto a substrate via a projection optical system to expose the substrate, wherein
the projection optical system comprises a first optical element that is closest to an image plane of the projection optical system and a second optical element that is closest to the image plane next to the first optical element, and
the exposure apparatus comprises an immersion mechanism that forms an immersion region of a liquid in a space between the first optical element and the second optical element; and
a detector that detects whether the liquid has leaked from the space.

17. The exposure apparatus according to Claim 16, wherein the detector comprises an optical fiber.

18. An exposure apparatus for emitting exposure light onto a substrate via a projection optical system to expose the substrate, comprising:
an immersion mechanism that forms an immersion region of a liquid on an upper surface of a predetermined optical element from among a plurality of optical elements constituting the projection optical system, wherein
a discharge outlet that discharges the liquid from the immersion region is provided in a supporting member holding the predetermined optical element.

19. The exposure apparatus according to Claim 18, wherein the supporting member holds an optical element disposed at a position closest to an image plane of the projection optical system.

20. The exposure apparatus according to Claim 18 or 19, wherein the discharge outlet is provided at a position lower than the upper surface of the predetermined optical element.

21. The exposure apparatus according to any one of Claims 18 to 20, further comprising a gas supply system that supplies a gas to the upper surface of the predetermined optical element when a liquid is discharged from the discharge outlet.

22. The exposure apparatus according to Claim 21, wherein
the immersion mechanism comprises at least one of a supply outlet that supplies a liquid to the upper surface of the predetermined optical element and a collection port that recovers the liquid, and
the gas supply system supplies a gas from at least one of the supply outlet and the collection port.

23. The exposure apparatus according to Claim 21 or 22, wherein the gas supply system comprises a gas port provided at the supporting member.

24. An exposure apparatus for emitting exposure light onto a substrate via a first optical element to expose the substrate, comprising:
a supply outlet that supplies a liquid to an upper surface side of the first optical element such that a predetermined region on the upper surface of the first optical element forms an immersion region, the exposure light passing through the predetermined region; and
a frame member that has a support portion that supports an outer circumferential portion of the first optical element and encloses the first optical element, wherein
the liquid supplied to the upper surface side of the first optical element is discharged from between the first optical element and the frame member.

25. The exposure apparatus according to Claim 24, wherein the liquid is discharged via a discharge outlet formed between the first optical element and the frame member.

26. The exposure apparatus according to Claim 24 or 25, wherein the discharge outlet has a cut portion provided at at least one of an outer marginal portion of the first optical element and an inner marginal portion of the frame member.

27. The exposure apparatus according to any one of Claims 24 to 26, wherein the supply outlet is provided outside the predetermined region.

28. The exposure apparatus according to any one of Claims 24 to 27, wherein the discharge outlet is provided at a position away from the supply outlet with respect to the predetermined region.

29. The exposure apparatus according to any one of Claims 25 to 28, further comprising a collection member that collects a liquid discharged from the discharge outlet.

30. The exposure apparatus according to Claim 29, further comprising a suction apparatus that suction-recovers the liquid collected by the collection member.

31. The exposure apparatus according to any one of Claims 24 to 30, further comprising a collection port that is provided at a position higher than the predetermined region and that recovers the liquid.

32. The exposure apparatus according to Claim 31, wherein the collection port is provided adjacent to the discharge outlet.

33. The exposure apparatus according to Claim 31 or 32, wherein the collection port is provided on the opposite side of the predetermined region from the supply outlet.

34. The exposure apparatus according to any one of Claims 24 to 33, further comprising a second optical element having a lower surface facing the upper surface of the first optical element, wherein
the liquid is held between the upper surface of the first optical element and the lower surface of the second optical element.

35. The exposure apparatus according to Claim 34, further comprising a projection optical system through which the exposure light passes, wherein
the first optical element is provided at a position closest to an image plane of the projection optical system, and
the second optical element is provided at a position closest to the image plane next to the first optical element.

36. A device manufacturing method, wherein the exposure apparatus according to any one of Claims 1 to 35 is used.
